# EUROPEAN PATENT APPLICATION

(11) **EP 4 636 487 A1**
(43) Date of publication of application: **22.10.2025**
(21) Application number: 23903476.2
(22) Date of filing: 11.12.2023
(51) Int. Cl.: G03F 7/11, G03F 7/20, H01L 21/027

(54) **COMPOSITION FOR FORMING RESIST UNDERLAYER FILM**

(30) Priority: 15.12.2022 JP 2022200212
(71) Applicant: Nissan Chemical Corporation, Tokyo 103-6119 (JP)
(72) Inventor: OGATA Hiroto, Toyama-shi, Toyama 939-2792 (JP); TAMURA Mamoru, Toyama-shi, Toyama 939-2792 (JP)
(74) Representative: Hoffmann Eitle
(86) International application number: PCT/JP2023/044231
(87) International publication number: WO 2024/128190

(57) **Abstract**

Provided is a resist underlayer film-forming composition including a polymer (A) a hydrophobic substituent-containing compound (B), and a solvent (C).

## Description

### Technical Field

The present invention relates to a resist underlayer film-forming composition, a resist underlayer film, a laminate, a method for producing a semiconductor element, and a method of forming a pattern.

### Background Art

In the related art, fine processing by lithography using resist compositions has been performed in the production of semiconductor devices. The fine processing is a processing method including: forming a photoresist composition thin film on a semiconductor substrate such as a silicon wafer; irradiating the thin film with active rays such as ultraviolet rays through a mask pattern having a device pattern drawn thereon; developing the irradiated thin film; and etching the substrate with the resultant photoresist pattern serving as a protective film to form, on the surface of the substrate, fine irregularities corresponding to the photoresist pattern. In recent years, semiconductor devices have become more highly integrated, and in addition to typically used active rays: i-line (wavelength: 365 nm), KrF excimer laser (wavelength: 248 nm), and ArF excimer laser (wavelength: 193 nm), the practical use of EUV light (wavelength: 13.5 nm) or electron beam (EB) in the most advanced fine processing has been studied. The use of such active rays has caused a serious problem in terms of defects in resist pattern formation due to an influence from a semiconductor substrate or the like. Thus, in order to solve this problem, a method of providing a resist underlayer film between a resist and a semiconductor substrate has been widely studied.

Patent Literature 1 discloses an underlayer film-forming composition for lithography including a naphthalene ring having a halogen atom. Patent Literature 2 discloses a halogenated anti-reflective coating. Patent Literature 3 discloses a resist underlayer film-forming composition.

### Citation List

### Patent Literature

Patent Literature 1: WO 2006/003850 A
Patent Literature 2: JP 2005-526270 A
Patent Literature 3: WO 2020/111068 A

### Summary of Invention

### Technical Problem

For example, a resist underlayer film is desirably characterized in that no intermixing with a resist film formed on an upper layer occurs (the resist film is insoluble in a resist solvent), and a fine resist pattern can be formed with high sensitivity.

The present invention has been made in view of the above circumstances, and an object of the present invention is to provide a resist underlayer film-forming composition capable of forming a resist underlayer film on which a fine resist pattern can be formed with high sensitivity, a resist underlayer film formed using the resist underlayer film-forming composition, a laminate, a method for producing a semiconductor element, and a method of forming a pattern.

### Solution to Problem

As a result of intensive studies to solve the above problem, the present inventors have found that the above problem can be solved, thereby completing the present invention having the following gist.

That is, the present invention includes the following items.
[1] A resist underlayer film-forming composition including a polymer (A), a hydrophobic substituent-containing compound (B), and a solvent (C).
[2] The resist underlayer film-forming composition according to [1], wherein the polymer (A) is at least one of an isocyanuric acid-based polymer, a polyester-based polymer, an acrylic polymer, or a polyether.
[3] The resist underlayer film-forming composition according to [1] or [2], wherein the polymer (A) is a polymer having a hydroxy group in a unit structure.
[4] The resist underlayer film-forming composition according to any one of [1] to [3], wherein the hydrophobic substituent of the compound (B) is an optionally substituted aryl group or an optionally substituted C₁₋₁₀ alkyl group.
[5] The resist underlayer film-forming composition according to any one of [1] to [4], wherein the solvent (C) contains at least one selected from the group consisting of alkylene glycol monoalkyl ether and monocarboxylic acid esters of alkylene glycol monoalkyl ether.
[6] The resist underlayer film-forming composition according to any one of [1] to [5], further including a crosslinking agent (D).
[7] The resist underlayer film-forming composition according to [6], wherein the crosslinking agent (D) is at least one selected from the group consisting of aminoplast crosslinking agent and phenoplast crosslinking agent.
[8] The resist underlayer film-forming composition according to any one of [1] to [7], further including a curing catalyst (E).
[9] A resist underlayer film that is a cured product of the resist underlayer film-forming composition according to any one of [1] to [8].
[10] A laminate including:
   a semiconductor substrate; and
   the resist underlayer film according to [9].
[11] A method for producing a semiconductor element, the method including the steps of:
   forming a resist underlayer film on a semiconductor substrate by using the resist underlayer film-forming composition according to any one of [1] to [8]; and
   forming a resist film on the resist underlayer film.
[12] A method of forming a pattern, the method including the steps of:
   forming a resist underlayer film on a semiconductor substrate by using the resist underlayer film-forming composition according to any one of [1] to [8];
   forming a resist film on the resist underlayer film;
   irradiating the resist film with light or an electron beam and then developing the resist film to obtain a resist pattern; and
   etching the resist underlayer film by using the resist pattern as a mask.

### Advantageous Effects of Invention

According to the present invention, it is possible to provide a resist underlayer film-forming composition capable of forming a resist underlayer film on which a fine resist pattern can be formed with high sensitivity, a resist underlayer film formed using the resist underlayer film-forming composition, a laminate, a method for producing a semiconductor element, and a method of forming a pattern.

### Description of Embodiments

### (Resist Underlayer Film-Forming Composition)

The resist underlayer film-forming composition of the present invention contains a polymer (A), a compound (B), and a solvent (C).

The resist underlayer film-forming composition may contain, for example, a crosslinking agent (D) and/or a curing catalyst (E).

Inclusion of the hydrophobic substituent-containing compound (B) in the resist underlayer film-forming composition enables formation of a fine resist pattern with higher sensitivity than the case without containing the hydrophobic substituent-containing compound (B).

### <Polymer (A)>

The polymer (A) is not particularly limited.

Examples of the polymer (A) include an organic polymer.

The polymer (A) is, for example, an isocyanuric acid-based polymer. The isocyanuric acid-based polymer refers to a polymer having the following isocyanuric acid skeleton. 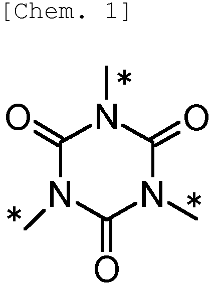 wherein * represents a bond.

Note that one of the bonds represented by * is optionally bonded to a hydrogen atom.

In addition, the polymer (A) is, for example, a polyester-based polymer. The polyester-based polymer refers to a polymer having an ester bond at least in the main chain. The ester bond in the polyester-based polymer is formed, for example, by reacting a -CO-X group (where X represents a hydroxy group, a halogen atom, or a C₁₋₄ alkoxy group) with a hydroxy group or an epoxy group.

Note that when a polymer has an isocyanuric acid skeleton and an ester bond in the main chain, the polymer is an isocyanuric acid-based polymer and also doubles as a polyester-based polymer.

In addition, the polymer (A) is, for example, an acrylic polymer. The acrylic polymer is, for example, a polymer formed by polymerizing a polymerizable unsaturated bond of a compound having a polymerizable unsaturated bond-containing group. The acrylic polymer may be a homopolymer or a copolymer. Examples of the polymerizable unsaturated bond-containing group include a (meth)acryloyl group, a vinylaryl group (e.g. a styryl group), a vinyloxy group, or an allyl group.

In addition, the polymer (A) is, for example, a polyether. The polyether is, for example, a product obtained by reacting a compound having two phenolic hydroxy groups and a compound having two epoxy groups.

Examples of the polyether include the polymer described in WO2022/071468. Such a polymer is, for example, a polymer derived from a compound (B) as represented by the following formula (11). 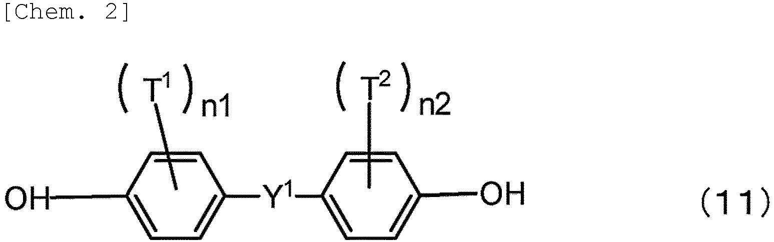 wherein in the formula (11), Y¹ represents a single bond, an oxygen atom, a sulfur atom, a C₁₋₁₀ alkylene group optionally substituted with a halogen atom or a C₆₋₄₀ aryl group, or a sulfonyl group, T¹ and T² each represent a C₁₋₁₀ alkyl group, and n1 and n2 each independently represent an integer of 0 to 4.

The polymer is, for example, a product obtained by reacting the compound (B) and the compound (C) capable of reacting with the compound (B).

The polymer (A) is, for example, a polymer having a hydroxy group in a unit structure. The hydroxy group is, for example, a hydroxy group bonded to a secondary carbon atom.

The polymer (A) may be, for example, a polymer having a unit structure represented by the following formula (P). The polymer having a unit structure represented by the following formula (P) may be, for example, the polymer described in WO2022/196662 (polymer having a unit structure represented by formula (P)). 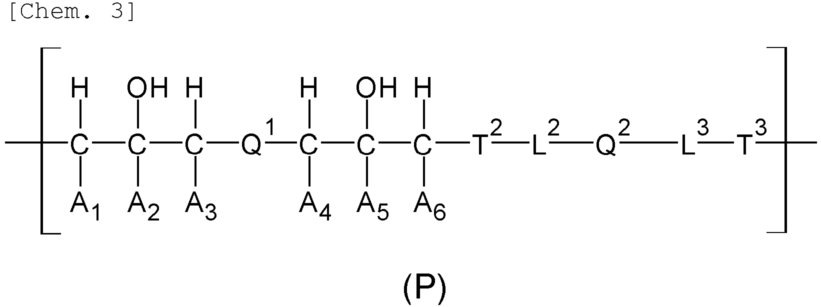
wherein in the formula (P), A₁, A₂, A₃, A₄, A₅, and A₆ each independently represent a hydrogen atom, a methyl group, or an ethyl group,
Q¹ and Q² each independently represent a divalent organic group containing a heterocyclic structure or a C₆₋₄₀ aromatic ring structure,
T² and T³ each independently represent a single bond, an ester bond, or an ether bond, and
L² and L³ each independently represent a single bond, an optionally substituted C₁₋₁₀ alkylene group, or an optionally substituted C₂₋₁₀ alkenylene group.

Specific examples of the unit structure represented by formula (P) are added.

Examples of Q¹ include the structure represented by the following formula (P-1): 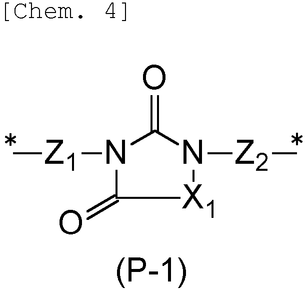
wherein in the formula (P-1), X₁ represents the following formula (P-1-1), the following formula (P-1-2), or the following formula (P-1-3);
Z₁ and Z₂ each independently represent a single bond or formula (P-1-4) described below; and
* represents a bond. 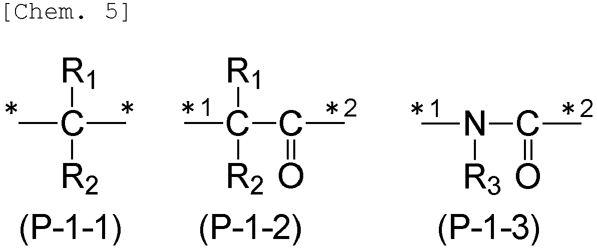
wherein in the formulas (P-1-1) to (P-1-2), R₁ and R₂ each independently represent a hydrogen atom, a C₁₋₁₀ alkyl group optionally interrupted by an oxygen atom or a sulfur atom, a C₂₋₁₀ alkenyl group optionally interrupted by an oxygen atom or a sulfur atom, a C₂₋₁₀ alkynyl group optionally interrupted by an oxygen atom or a sulfur atom, a benzyl group, or a phenyl group, where the phenyl group is optionally substituted with at least one monovalent group selected from the group consisting of a C₁₋₆ alkyl group, a halogen atom, a C₁₋₆ alkoxy group, a nitro group, a cyano group, and a C₁₋₆ alkylthio group, R₁ and R₂ are optionally bonded to each other to form a C₃₋₆ ring,* represents a bond, *1 represents a bond bonded to a carbon atom, and *2 represents a bond bonded to a nitrogen atom;
in the formula (P-1-3), R₃ represents a hydrogen atom,
a C₁₋₁₀ alkyl group optionally interrupted with an oxygen atom or a sulfur atom, a C₂₋₁₀ alkenyl group optionally interrupted with an oxygen atom or a sulfur atom, a C₂₋₁₀ alkynyl group optionally interrupted with an oxygen atom or a sulfur atom, a benzyl group, or a phenyl group, and the phenyl group is optionally substituted with at least one monovalent group selected from the group consisting of a C₁₋₆ alkyl group, a halogen atom, a C₁₋₆ alkoxy group, a nitro group, a cyano group, and a C₁₋₆ alkylthio group, *1 represents a bond bonded to a carbon atom, and *2 represents a bond bonded to a nitrogen atom. 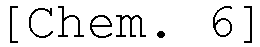 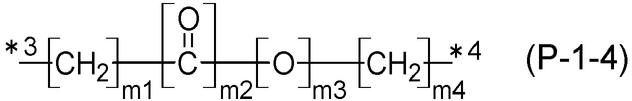
wherein in the formula (P-1-4), m1 is an integer of 0 to 4, m2 is 0 or 1, m3 is 0 or 1, and m4 is an integer of 0 to 2, provided that in a case where m3 is 1, m1 and m2 are not simultaneously 0; *3 represents a bond to a nitrogen atom in formula (P-1); and *4 represents a bond.

In the present specification, examples of the halogen atom include a fluorine atom, a chlorine atom, a bromine atom, and an iodine atom.

In the present specification, an alkyl group is not limited to a linear alkyl group, and may be branched or cyclic. Examples of the linear or branched alkyl group include a methyl group, an ethyl group, an isopropyl group, a tert-butyl group, and an n-hexyl group. Examples of the cyclic alkyl group (cycloalkyl group) include a cyclobutyl group, a cyclopentyl group, and a cyclohexyl group.

In the present specification, examples of an alkoxy group include a methoxy group, an ethoxy group, an n-pentyloxy group, and an isopropoxy group.

In the present specification, examples of an alkylthio group include a methylthio group, an ethylthio group, an n-pentylthio group, and an isopropylthio group.

In the present specification, examples of an alkenyl group include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, and a 2-methyl-2-propenyl group.

In the present specification, examples of an alkynyl group include groups in which a double bond of an alkenyl group listed above as an "alkenyl group" is replaced with a triple bond.

In the present specification, examples of an alkenyloxy group include a vinyloxy group, a 1-propenyloxy group, a 2-n-propenyloxy group (allyloxy group), a 1-n-butenyloxy group, and a prenyloxy group.

In the present specification, examples of an alkynyloxy group include a 2-propynyloxy group, a 1-methyl-2-propynyloxy group, a 2-methyl-2-propynyloxy group, a 2-butynyloxy group, and a 3-butynyloxy group.

In the present specification, examples of an acyl group include an acetyl group and a propionyl group.

In the present specification, examples of an aryloxy group include a phenoxy group and naphthyloxy.

In the present specification, examples of an arylcarbonyl group include a phenylcarbonyl group.

In the present specification, examples of an aralkyl group include a benzyl group and a phenethyl group.

In the present specification, examples of an alkylene group include a methylene group, an ethylene group, a 1,3-propylene group, a 2,2-propylene group, a 1-methylethylene group, a 1,4-butylene group, a 1-ethylethylene group, a 1-methylpropylene group, a 2-methylpropylene group, a 1,5-pentylene group, a 1-methylbutylene group, a 2-methylbutylene group, a 1,1-dimethylpropylene group, a 1,2-dimethylpropylene group, a 1-ethylpropylene group, a 2-ethylpropylene group, a 1,6-hexylene group, a 1,4-cyclohexylene group, a 1,8-octylene group, a 2-ethyloctylene group, a 1,9-nonylene group, and a 1,10-decylene group.

Examples of the structure represented by formula (P-1) include the following structures. 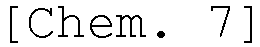 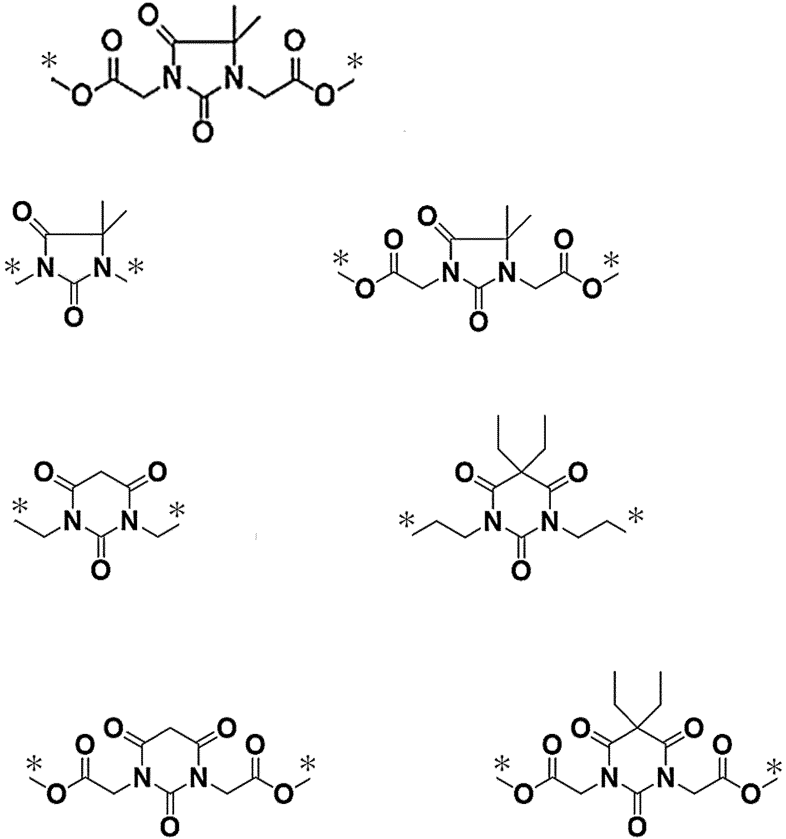 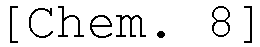 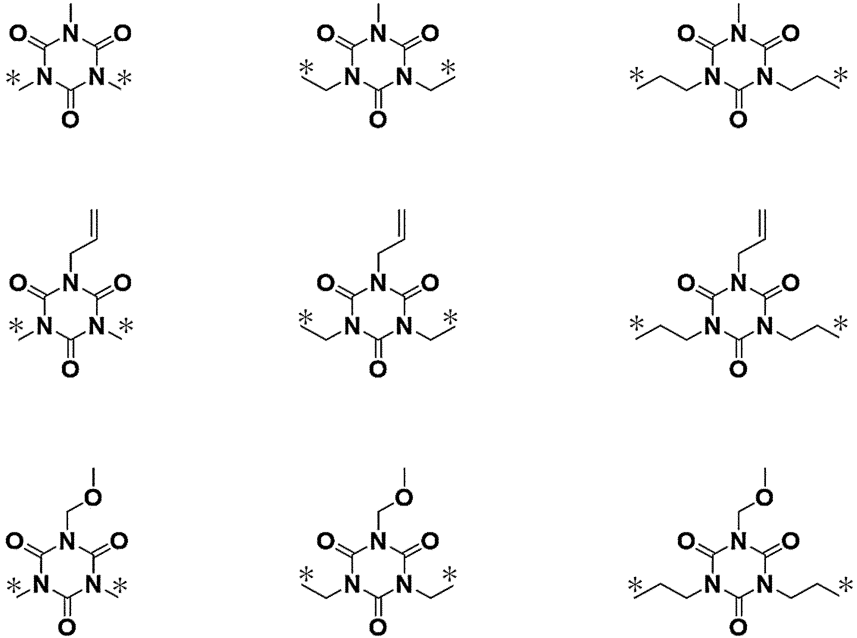 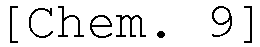 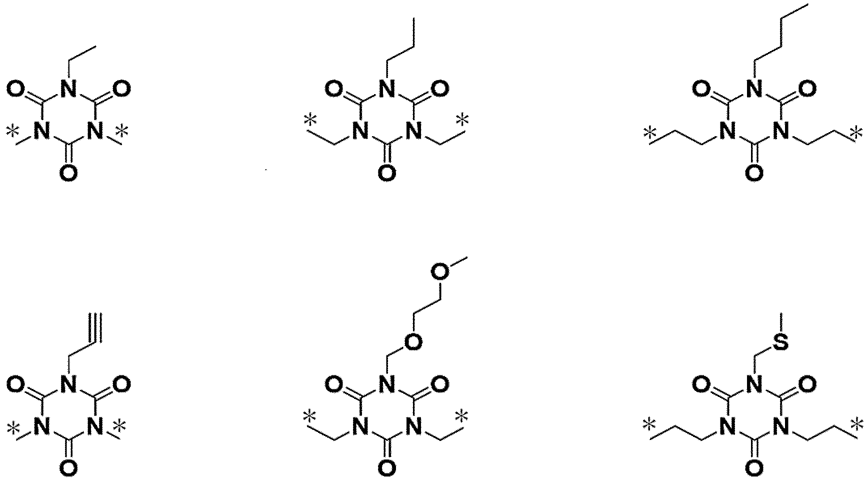 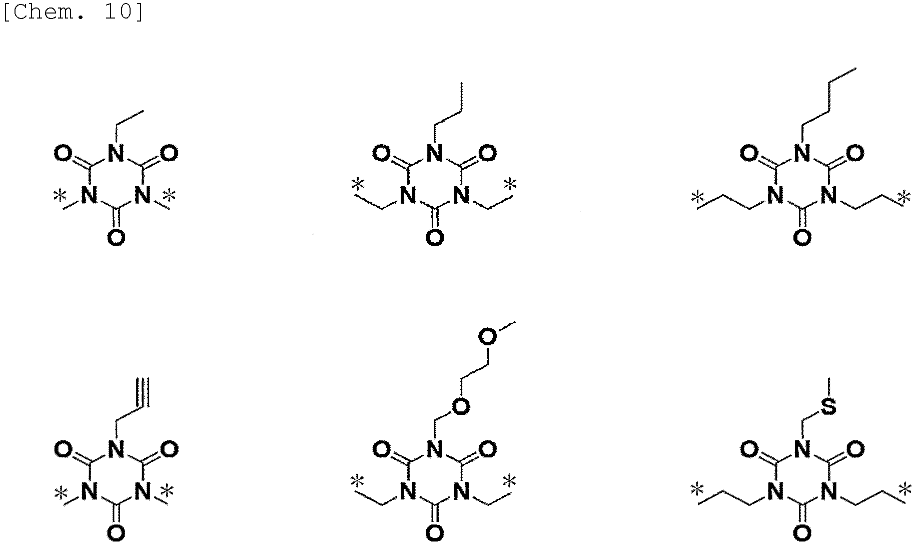 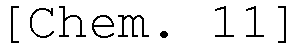 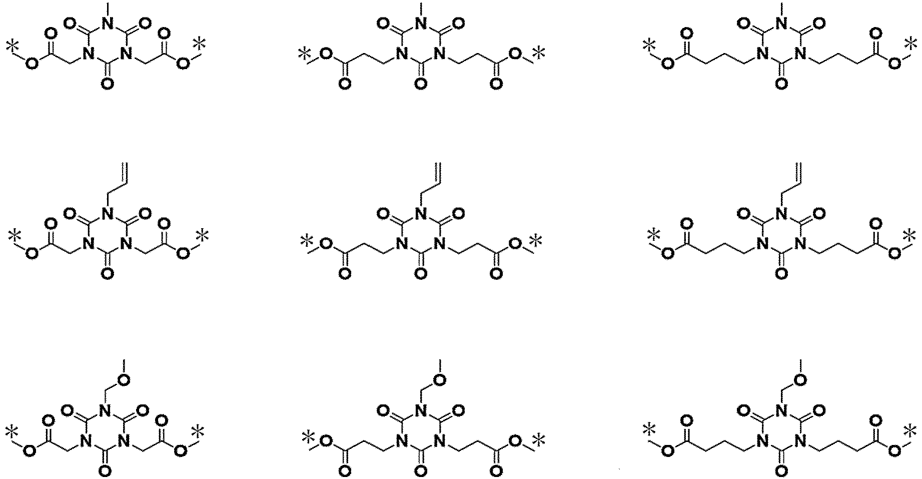 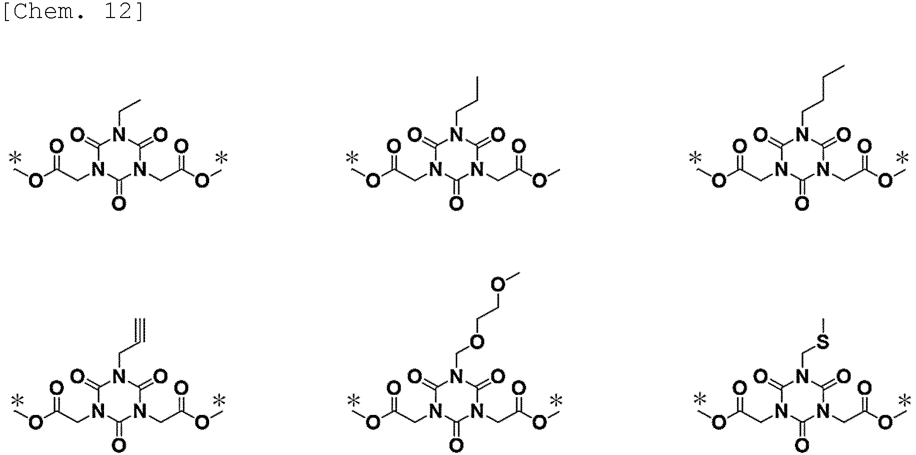 (* represents a bond.)

Examples of the C₆₋₄₀ aromatic ring in Q¹ and Q² include aromatic rings derived from benzene, naphthalene, anthracene, acenaphthene, fluorene, triphenylene, phenalene, phenanthrene, indene, indane, indacene, pyrene, chrysene, perylene, naphthacene, pentacene, coronene, heptacene, benzo[a]anthracene, dibenzophenanthrene, and/or dibenzo[a,j]anthracene. Among them, preferred are those selected from benzene, naphthalene, and anthracene.

Examples of the divalent organic group containing a C₆₋₄₀ aromatic ring structure in Q¹ and Q² include an optionally substituted divalent C₆₋₄₀ aromatic group.

Examples of the substituent include a halogen atom, a hydroxy group, a carboxy group, a cyano group, a nitro group, a C₁₋₆ alkyl group, or a C₁₋₆ alkoxy group.

Examples of -T²-L²-Q²-L³-T³- in the formula (P) include the following divalent organic groups. 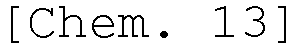 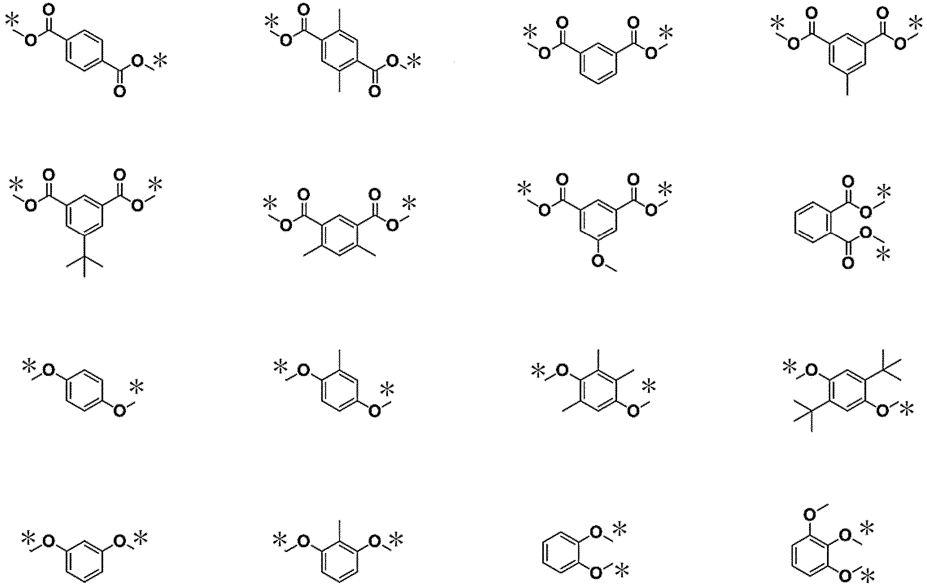 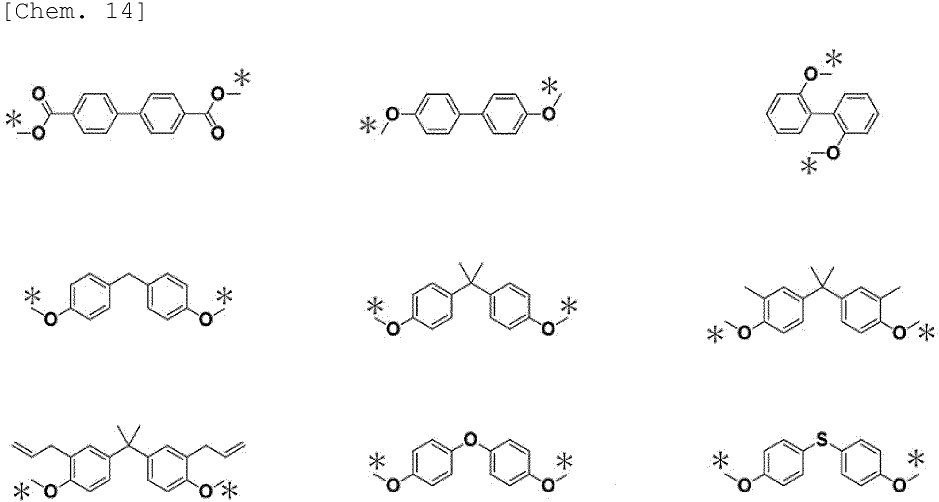 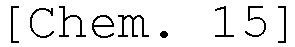 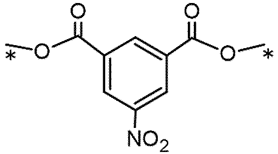 (* represents a bond.)

The polymer (A) may be, for example, each polymer described in WO2009/008446, WO2011/074494, WO2013/018802, and the like described below.

·A polymer having a repeating unit structure represented by the following formula (1) described in WO2009/008446. 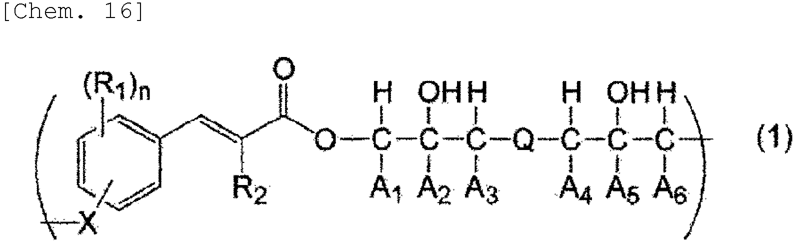 wherein in the formula (1), R₁ represents a methoxy group, a C₁₋₁₃ alkyl group, or a halogen atom, n represents an integer of 0 to 4, R₂ represents a hydrogen atom, a cyano group, a phenyl group, a C₁₋₁₃ alkyl group, or a halogen atom, X represents an ether bond or an ester bond, A₁, A₂, A₃, A₄, A₅, and A₆ each independently represent a hydrogen atom, a methyl group, or an ethyl group, and Q represents a divalent organic group between two carbon atoms.
· A polymer having a repeating unit structure represented by the following formula (1) described in WO2011/074494. 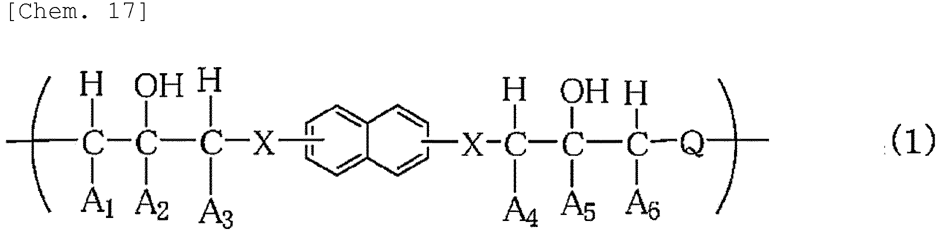
   wherein in the formula (1), X represents an ether bond or an ester bond, and A₁, A₂, A₃, A₄, A₅, and A₆ each independently represent a hydrogen atom, a methyl group, or an ethyl group and Q represents the following formula (2) or the following formula (3): 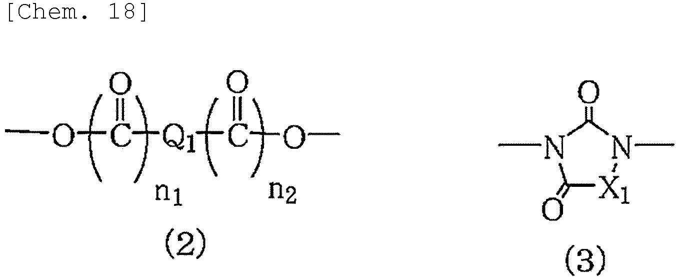
   wherein in the formulas (2) and (3), Q₁ represents a C₁₋₁₀ alkylene group, a phenylene group, a naphthylene group, or an anthrylene group, and the phenylene group, the naphthylene group, and the anthrylene group are each optionally substituted with a group selected from the group consisting of a C₁₋₆ alkyl group, a halogen atom, a C₁₋₆ alkoxy group, a nitro group, a cyano group, a hydroxy group, and a C₁₋₆ alkylthio group, n₁ and n₂ each represent a number of 0 or 1, and X₁ represents the following formula (4), the following formula (5), or the following formula (6) : 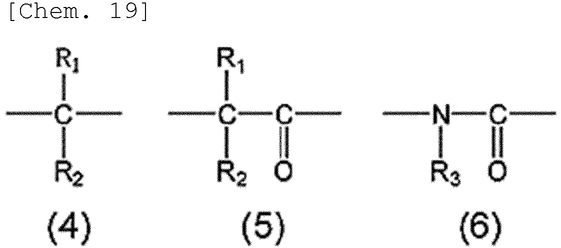
   wherein in the formulas (4), (5), and (6), R¹ and R² each represent a hydrogen atom, a C₁₋₆ alkyl group, a C₂₋₆ alkenyl group, a benzyl group, or a phenyl group, and the benzyl group and the phenyl group are each optionally substituted with a group selected from the group consisting of a C₁₋₆ alkyl group, a halogen atom, a C₁₋₆ alkoxy group, a nitro group, a cyano group, a hydroxy group, and a C₁₋₆ alkylthio group, and R¹ and R² are optionally bonded to each other to form a C₃₋₆ ring, R³ represents a C₁₋₆ alkyl group, a C₂₋₆ alkenyl group, a benzyl group, or a phenyl group, and the benzyl group and the phenyl group are each optionally substituted with a group selected from the group consisting of a C₁₋₆ alkyl group, a halogen atom, a C₁₋₆ alkoxy group, a nitro group, a cyano group, a hydroxy group, and a C₁₋₆ alkylthio group.
· A polymer having a structure of the following formula (1a) described in WO2013/018802. 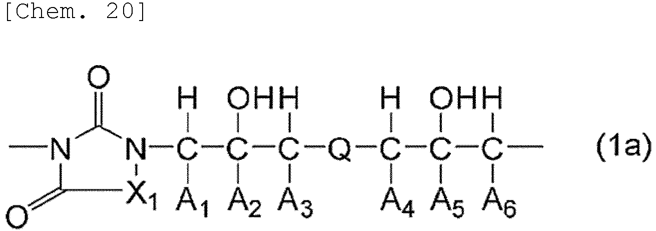
   wherein in the formula (1a), A₁, A₂, A₃, A₄, A₅, and A₆ each independently represent a hydrogen atom, a methyl group, or an ethyl group, X₁ represents the following formula (2), the following formula (3), the following formula (4) or the following formula (0):, and Q represents the following formula (5) or the following formula (6): 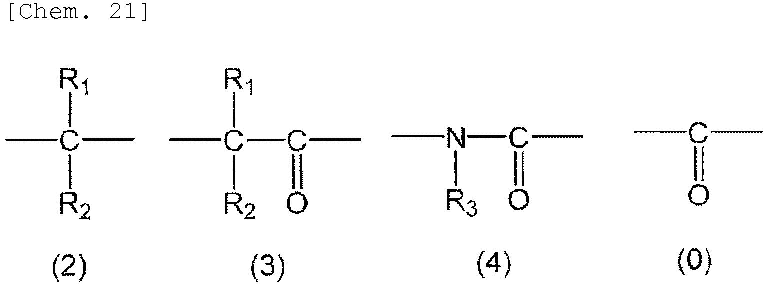
   wherein in the formulas (2), (3), (4), and (0), R₁ and R₂ each represent a hydrogen atom, a halogen atom, a C₁₋₆ alkyl group, a C₃₋₆ alkenyl group, a benzyl group, or a phenyl group, and the C₁₋₆ alkyl group, the C₃₋₆ alkenyl group, the benzyl group, and the phenyl group are each optionally substituted with a group selected from the group consisting of a C₁₋₆ alkyl group, a halogen atom, a C₁₋₆ alkoxy group, a nitro group, a cyano group, a hydroxy group, a carboxyl group, and a C₁₋₆ alkylthio group, and R₁ and R₂ are optionally bonded to each other to form a C₃₋₆ ring, R₃ represents a halogen atom, a C₁₋₆ alkyl group, a C₃₋₆ alkenyl group, a benzyl group, or a phenyl group, and the phenyl group is optionally substituted with a group selected from the group consisting of a C₁₋₆ alkyl group, a halogen atom, a C₁₋₆ alkoxy group, a nitro group, a cyano group, a hydroxy group, and a C₁₋₆ alkylthio group. 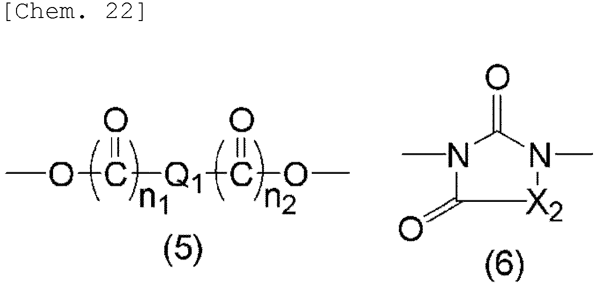
   wherein in the formulas (5) and (6), Q₁ represents a C₁₋₁₀ alkylene group, a phenylene group, a naphthylene group, or an anthrylene group, and the alkylene group, the phenylene group, the naphthylene group, and the anthrylene group are each optionally substituted with a C₁₋₆ alkyl group, a C₂₋₇ carbonyloxyalkyl group, a halogen atom, a C₁₋₆ alkoxy group, a phenyl group, a nitro group, a cyano group, a hydroxy group, a C₁₋₆ alkylthio group, a disulfide group-containing group, a carboxyl group or a combination thereof, n₁ and n₂ each represent a number of 0 or 1, and X₂ represents the above formula (2), the above formula (3), the above formula (4), or the above formula (0).

In addition, the polymer (A) may have a repeating structural unit containing at least one -C(=O)-O- group in a main chain and a repeating structural unit containing at least one hydroxy group in a side chain, or may be a resin having a repeating structural unit containing at least one -C(=O)-O- group in a main chain and at least one hydroxy group in a side chain as described in WO2020/026834.

Further, the polymer (A) may be a copolymer having a repeating structural unit represented by the following formula (1-1) or a repeating structural unit represented by the following formula (1-2): 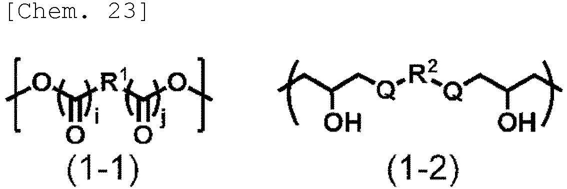 wherein in the formulas (1-1) and (1-2), R¹ and R² each independently represent a divalent organic group containing a linear, branched, or cyclic C₂₋₂₀ functional group, the organic group optionally has at least one sulfur atom, nitrogen atom, or oxygen atom; i and j each independently represent 0 or 1; and two Q moieties each represent a single bond, an -O- group, or a -C(=O)-O- group, provided that when both i and j are 0, at least one Q of the two Q moieties represents a -C(=O)-O- group.

Note that as to the polymer (A), the contents of the polymers described in WO2022/196662, WO2009/008446, WO2011/074494, WO2013/018802, WO2020/026834, and WO2022/071468 are incorporated herein to the same extent to which all are explicitly described.

The polymer (A) may have a structure represented by the following formula (E). The structure represented by the formula (E) is, for example, located at the end(s) (one end or both ends) of the polymer (A). 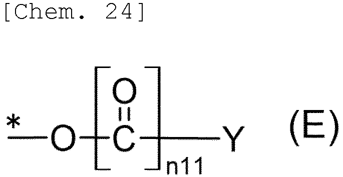 wherein in the formula (E), Y represents a monovalent group, and n11 represents 0 or 1.

Examples of the monovalent group in Y in the formula (E) include a monovalent C₁₋₃₀ organic group.

Examples of Y in the formula (E) include a monovalent residual group obtained by removing one hydrogen atom from an aliphatic ring optionally substituted with a substituent, or a monovalent aromatic group optionally substituted with a substituent.

Examples of the substituent include a halogen atom, a hydroxy group, a C₁₋₆ alkyl group, or a C₁₋₆ alkoxy group.

Examples of the aromatic group in the monovalent aromatic group optionally substituted with a substituent include an aromatic hydrocarbon group. Examples of the aromatic hydrocarbon group include a phenyl group, a naphthyl group, or an anthracenyl group.

Examples of the compound represented by the formula (EA) include the following compounds.

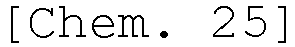

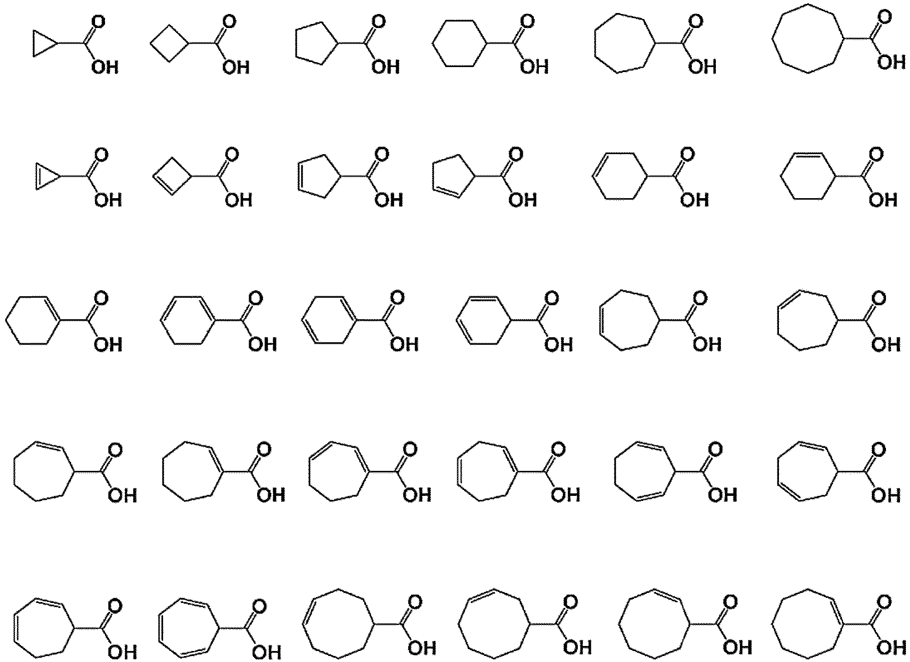

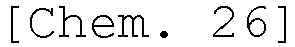

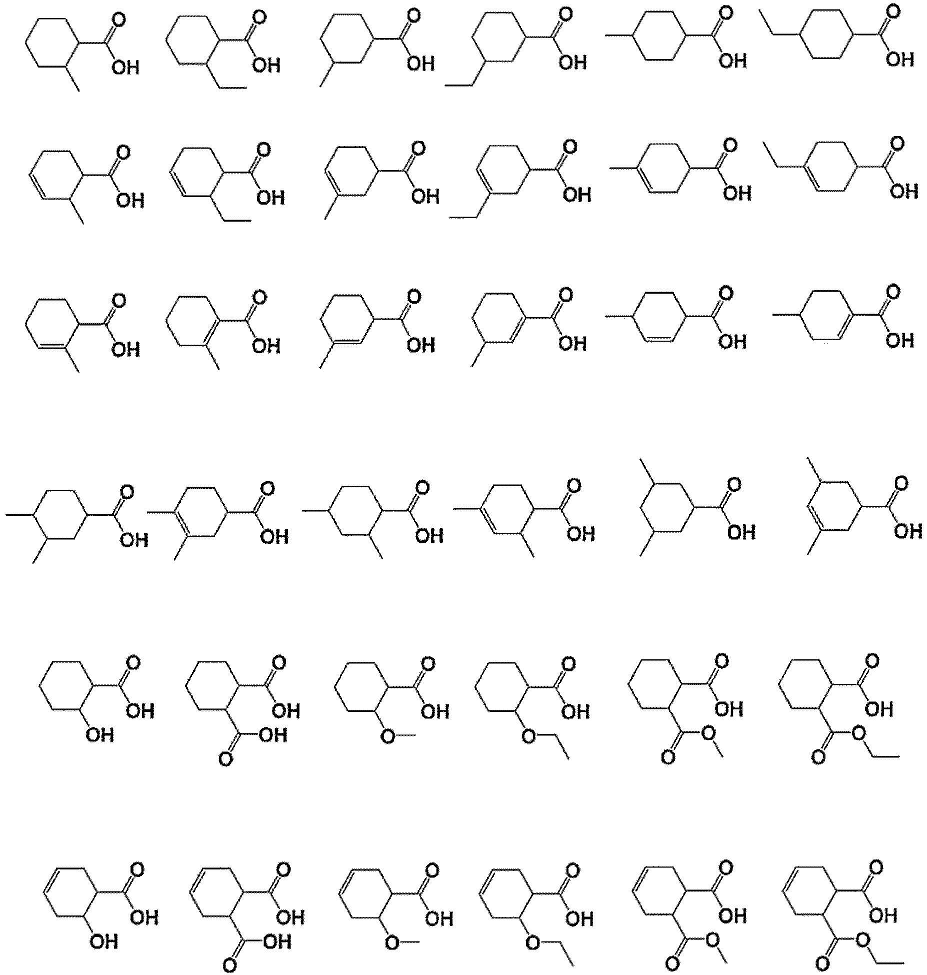

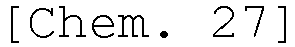

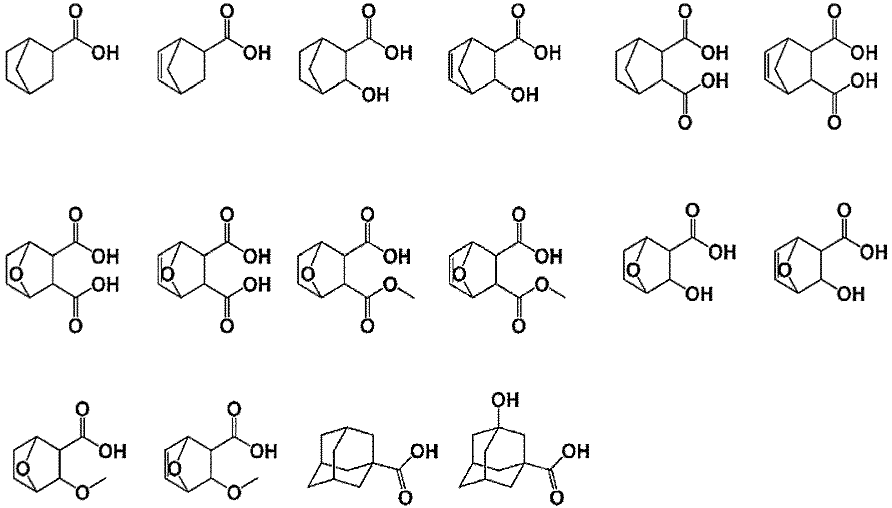

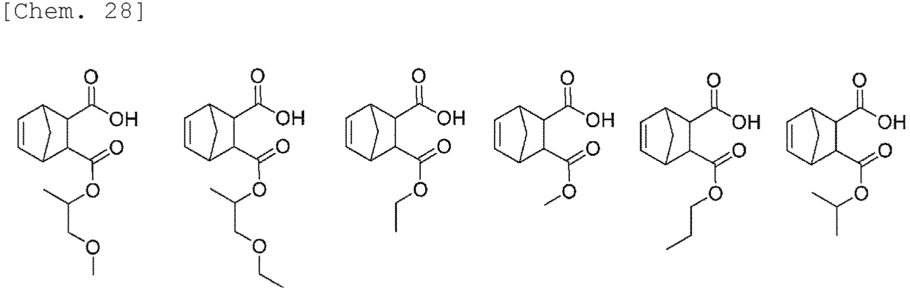

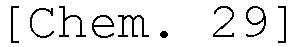

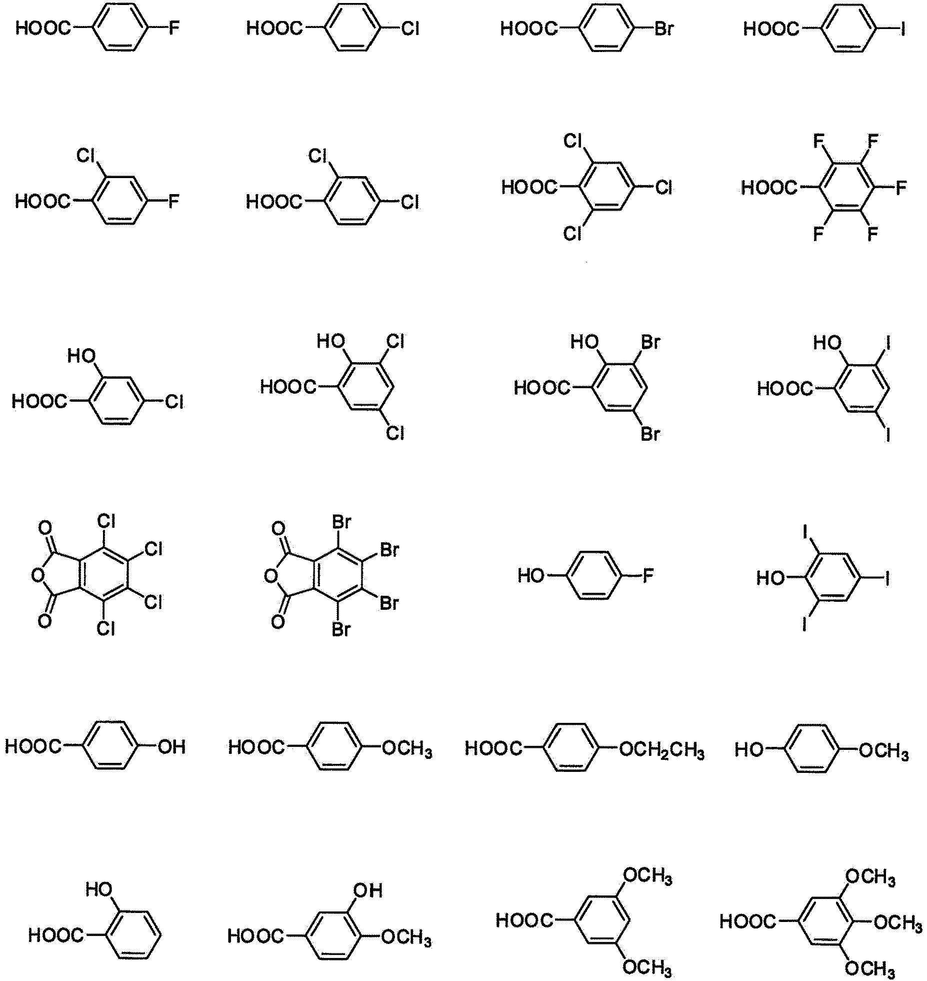

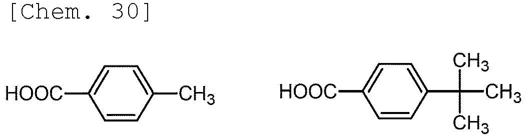

The molecular weight of the polymer (A) is not particularly limited.

The lower limit of the weight-average molecular weight of the polymer (A) is, for example, 500, 1,000, 2,000, or 3,000.

The upper limit of the weight-average molecular weight of the polymer (A) is, for example, 30,000, 20,000, or 10,000.

The content of the polymer (A) in the resist underlayer film-forming composition is not particularly limited, but is preferably 50 mass% to 99 mass%, more preferably 60 mass% to 95 mass%, and particularly preferably 65 mass% to 90 mass% based on the film constituent components from the viewpoint of suitably obtaining the effect of the present invention.

Note that in the present invention, the film constituent components mean components other than the solvent contained in the composition.

### <Compound (B)>

The compound (B) is a hydrophobic substituent-containing compound.

The compound (B) may be added to the resist underlayer film-forming composition to increase the hydrophobicity of the resist underlayer film formed from the resist underlayer film-forming composition.

Note that the compound (B) has a structure different from that of the polymer (A).

The hydrophobic substituent of the compound (B) is not particularly limited, but from the viewpoint of suitably obtaining the effect of the present invention, an optionally substituted aryl group or an optionally substituted C₁₋₁₀ alkyl group is preferable.

Examples of the substituent in the optionally substituted aryl group include a hydroxy group, a halogen atom, a C₁₋₁₀ alkyl group, a C₁₋₁₀ alkoxy group, a halogenated C₁₋₁₀ alkyl group, a halogenated C₁₋₁₀ alkoxy group, or an R^{x}OC(=O)- group (where R^{x} represents a hydrogen atom, a C₁₋₄ alkyl group, or an alkoxyalkyl group having a total of 2 to 6 carbon atoms).

Examples of the aryl group in the optionally substituted aryl group include a phenyl group or a naphthyl group.

Examples of the substituent in the optionally substituted C₁₋₁₀ alkyl group include a hydroxy group, a halogen atom, a C₁₋₁₀ alkoxy group, a halogenated C₁₋₁₀ alkoxy group, or a carboxy group.

Note that the hydroxy group and the carboxy group are hydrophilic groups, but when the hydrophobic substituents are hydrophobic as a whole, the hydrophobic substituent may have a hydrophilic group.

From the viewpoint of suitably obtaining the effect of the present invention, the compound (B) preferably has, as a hydrophobic substituent, at least one group represented by the following formula (X). 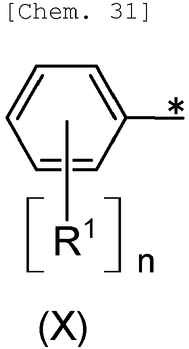 wherein in the formula (X), R¹ represents a monovalent group other than a hydrogen atom, n represents an integer of 0 to 5, and when two or more R¹ moieties are present, the two or more R¹ moieties are the same or different.

Examples of R¹ in the formula (X) include a hydroxy group, a halogen atom, a C₁₋₁₀ alkyl group, a C₁₋₁₀ alkoxy group, a halogenated C₁₋₁₀ alkyl group, a halogenated C₁₋₁₀ alkoxy group, or an R^{x}OC(=O)- group (where R^{x} represents a hydrogen atom, a C₁₋₄ alkyl group, or an alkoxyalkyl group having a total of 2 to 6 carbon atoms).

The compound (B) has, for example, a group represented by the following formula (Q-1) or a group represented by the following formula (Q-2): 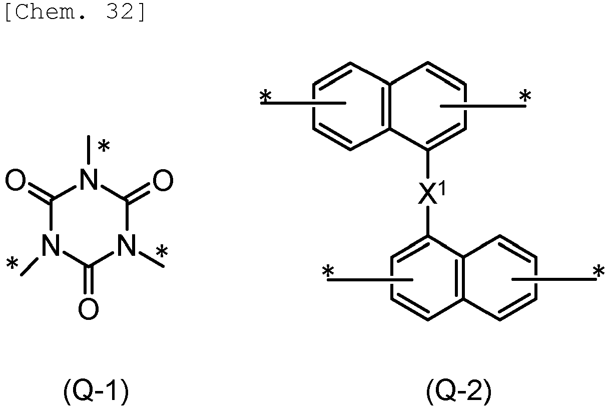 wherein in the formulas (Q-1) and (Q-2), * represents a bond, and X¹ represents a single bond, an oxygen atom, or a C₁₋₆ alkylene group.

From the viewpoint of suitably obtaining the effect of the present invention, the compound (B) is preferably a compound represented by the following formula (Y): 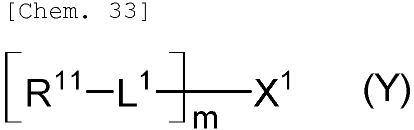 wherein in the formula (Y), X¹ represents an m-valent group,
- R¹¹: represents a hydrophobic substituent,
- L¹: represents a single bond or a divalent group,
- m: represents an integer of 1 to 4,

when two or more R¹¹ moieties are present, the two or more R¹¹ moieties are the same or different, and
when two or more L¹ moieties are present, the two or more L¹ moieties are the same or different.

The hydrophobic substituent for R¹¹ in the formula (Y) is preferably an optionally substituted aryl group or an optionally substituted C₁₋₁₀ alkyl group.

In addition, as the hydrophobic substituent, a group represented by formula (X) is preferable.

Examples of the L¹ in the formula (Y) include a divalent group represented by the following formula (L): 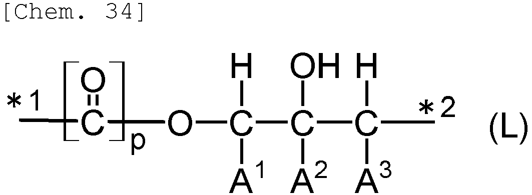
wherein in the formula (L), A¹, A², and A³ each independently represent a hydrogen atom, a methyl group, or an ethyl group,
p represents an integer of 0 or 1,
*1 represents a bond bonded to R¹¹ in formula (Y), and
*2 represents a bond bonded to X¹ in formula (Y).

X¹ in the formula (Y) has, for example, a ring structure. Examples of the ring structure include an aromatic ring, an aliphatic ring, or a non-aromatic heterocycle. Examples of the aromatic ring include a benzene ring or a naphthalene ring. Examples of the alicyclic ring include a cyclohexane ring. Examples of the non-aromatic heterocycle include a ring structure represented by the above formula (Q-1).

Examples of X¹ in formula (Y) include the following groups. In the following groups, * represents a bond.

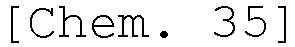

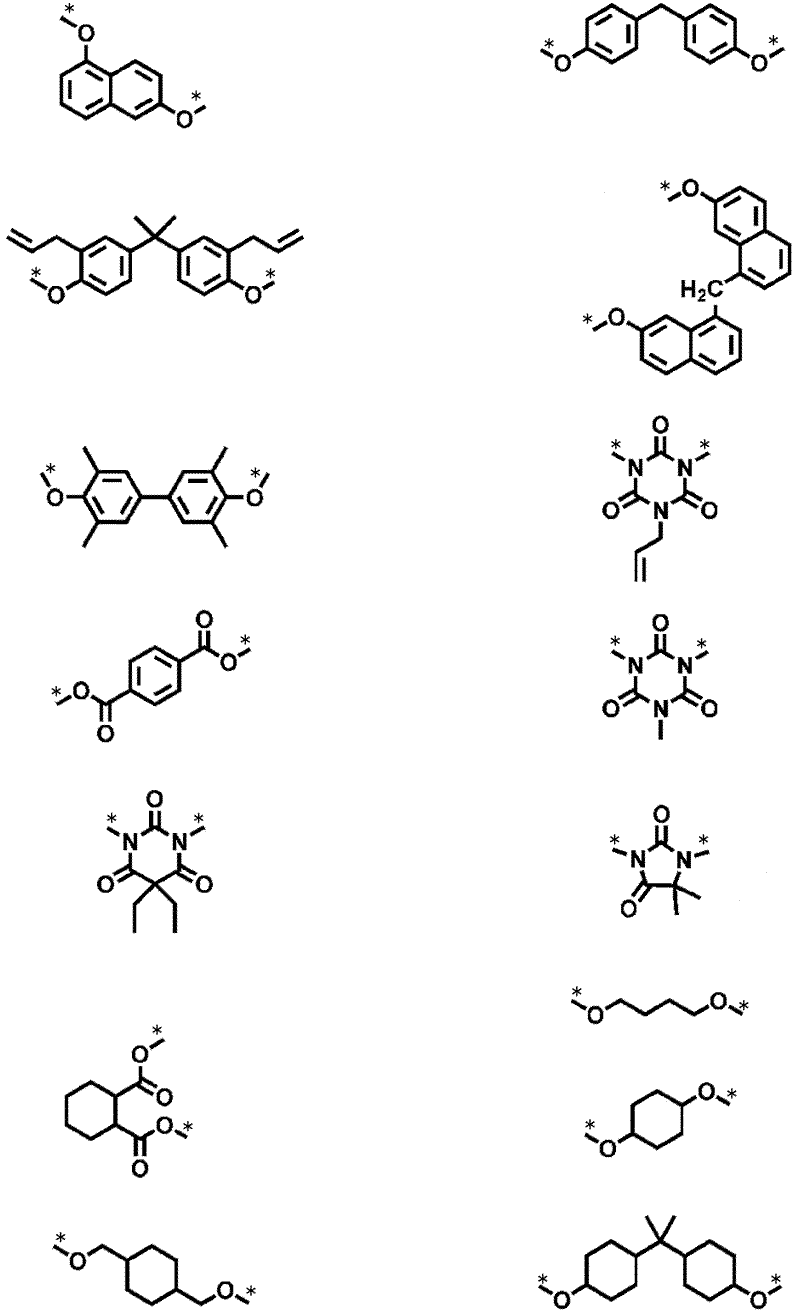

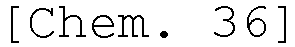

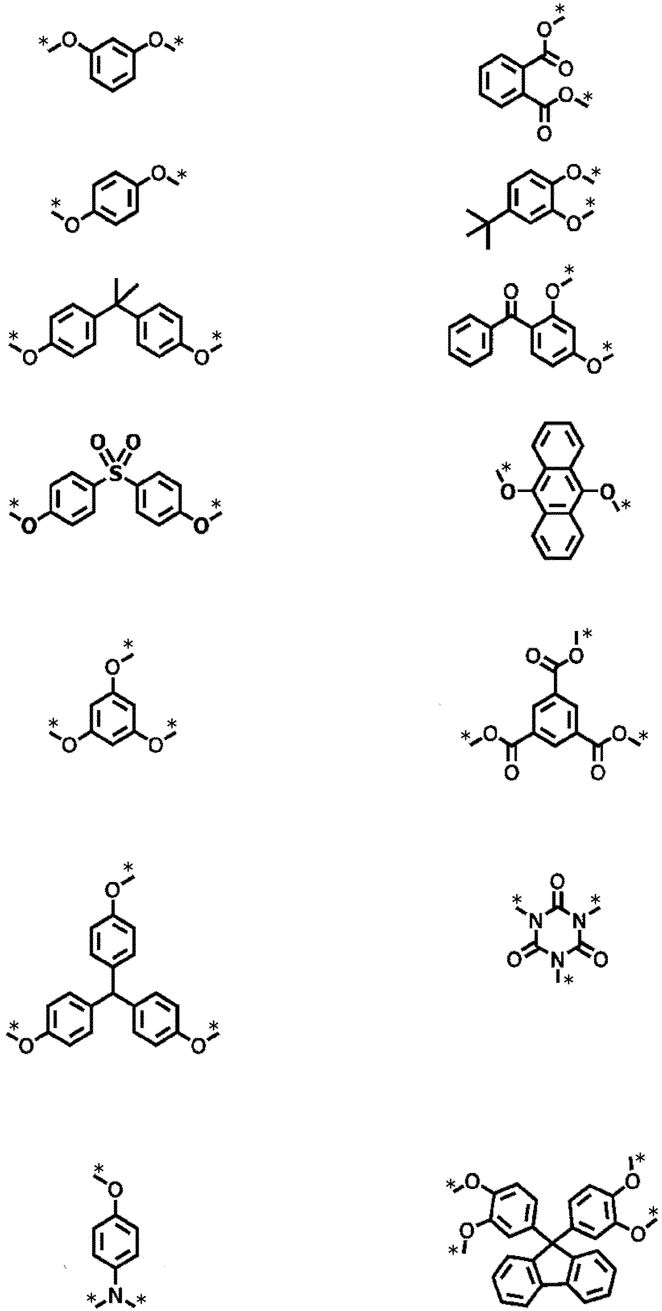

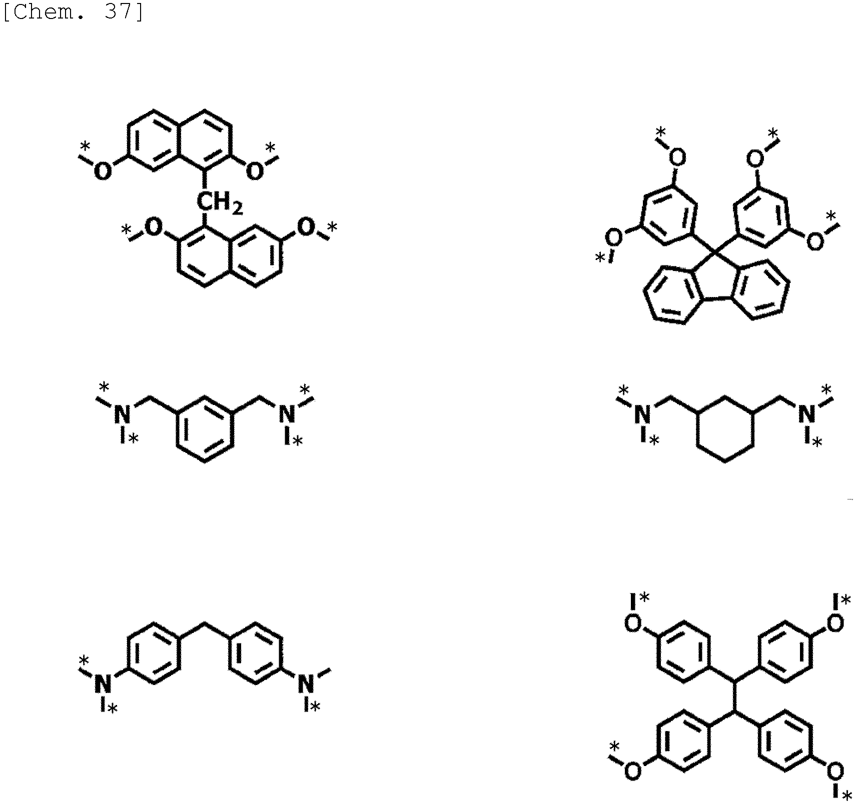

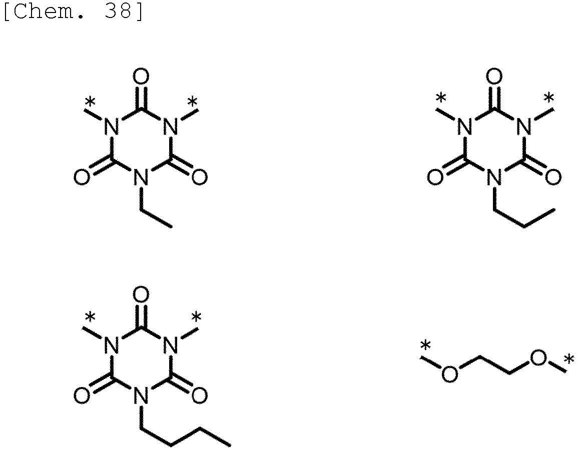

From the viewpoint of suitably obtaining the effect of the present invention, the compound (B) is preferably at least one of a compound represented by the following formula (Y1) or a compound represented by the following formula (Y2): 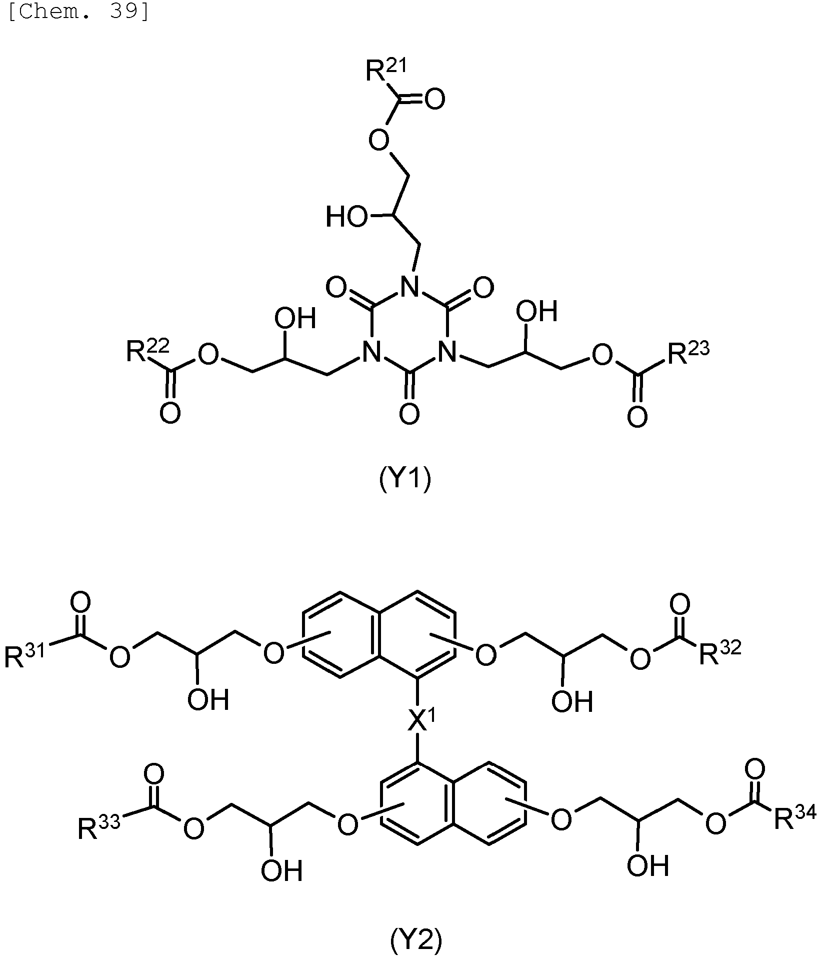
wherein in the formula (Y1), R²¹ to R²³ each independently represent a hydrophobic substituent,
in the formula (Y2), R³¹ to R³⁴ each independently represent a hydrophobic substituent, and X¹ represents a single bond, an oxygen atom, or a C₁₋₆ alkylene group.

Examples of the compound (B) include the following compounds.

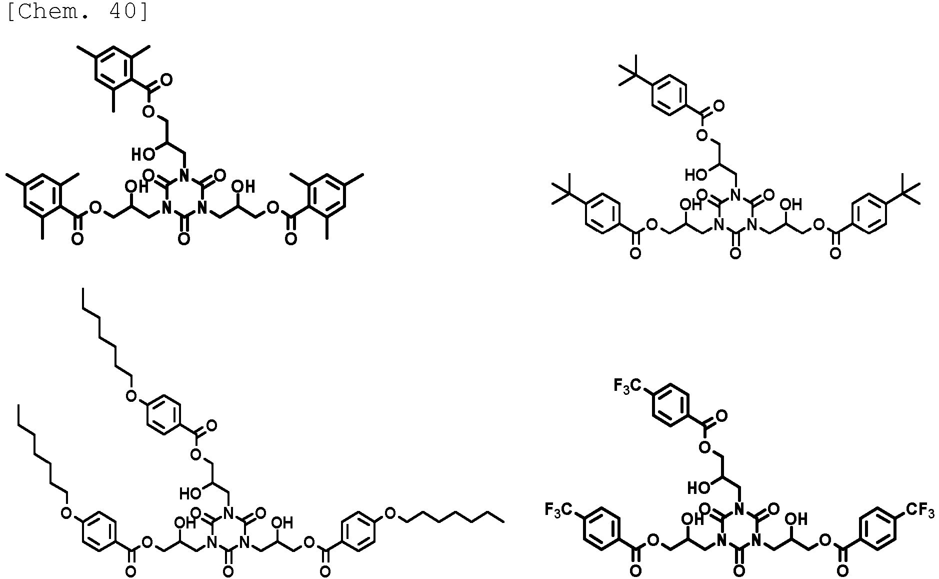

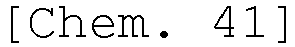

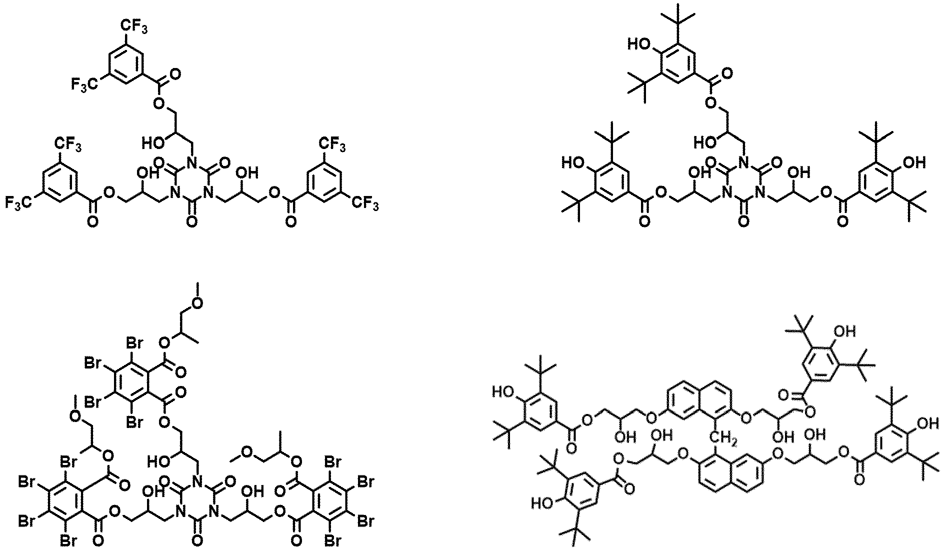

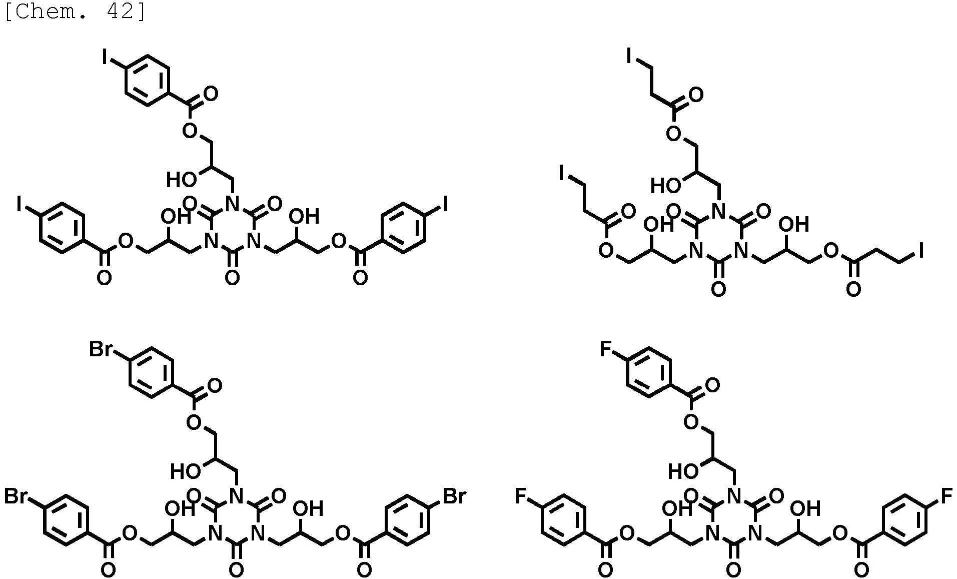

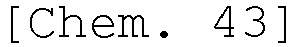

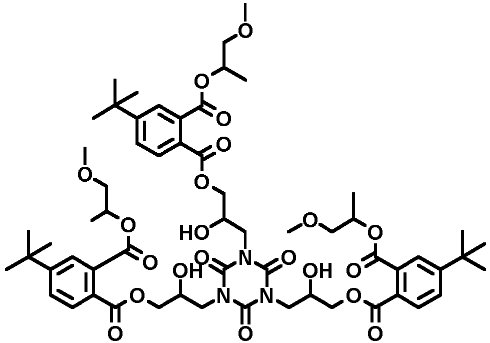

The compound represented by the formula (Y) can be obtained, for example, by reacting a compound represented by the following formula (Y-1) with at least one of a compound represented by the following formula (Y-2-1) or a compound represented by the following formula (Y-2-2): 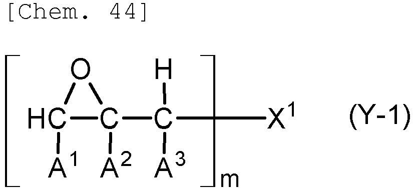
wherein in the formula (Y-1), X¹ represents an m-valent group,
A¹, A², and A³ each independently represent a hydrogen atom, a methyl group, or an ethyl group, and
m represents an integer of 1 to 4.

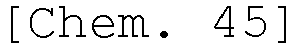

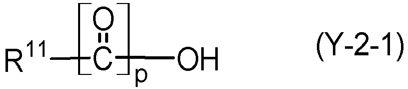

wherein in the formula (Y-2-1), R¹¹ represents a hydrophobic substituent, and
p represents an integer of 0 or 1.

The hydrophobic substituent for R¹¹ in the formula (Y-2-1) is preferably an optionally substituted aryl group or an optionally substituted C₁₋₁₀ alkyl group.

In addition, as the hydrophobic substituent, a group represented by formula (X) is preferable. 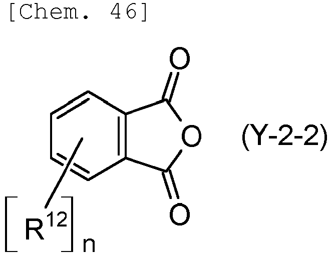 wherein in the formula (Y-2-2), R¹² represents a monovalent group other than a hydrogen atom, n represents an integer of 0 to 4, and when two or more R¹² moieties are present, the two or more R¹² moieties are the same or different.

Examples of R¹² in the formula (Y-2-2) include a hydroxy group, a halogen atom, a C₁₋₁₀ alkyl group, a C₁₋₁₀ alkoxy group, a halogenated C₁₋₁₀ alkyl group, a halogenated C₁₋₁₀ alkoxy group, or an R^{x}OC(=O)- group (where R^{x} represents a hydrogen atom, a C₁₋₄ alkyl group, or an alkoxyalkyl group having a total of 2 to 6 carbon atoms).

Examples of the compound represented by formula (Y-1) include the following compounds:

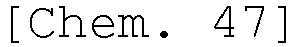

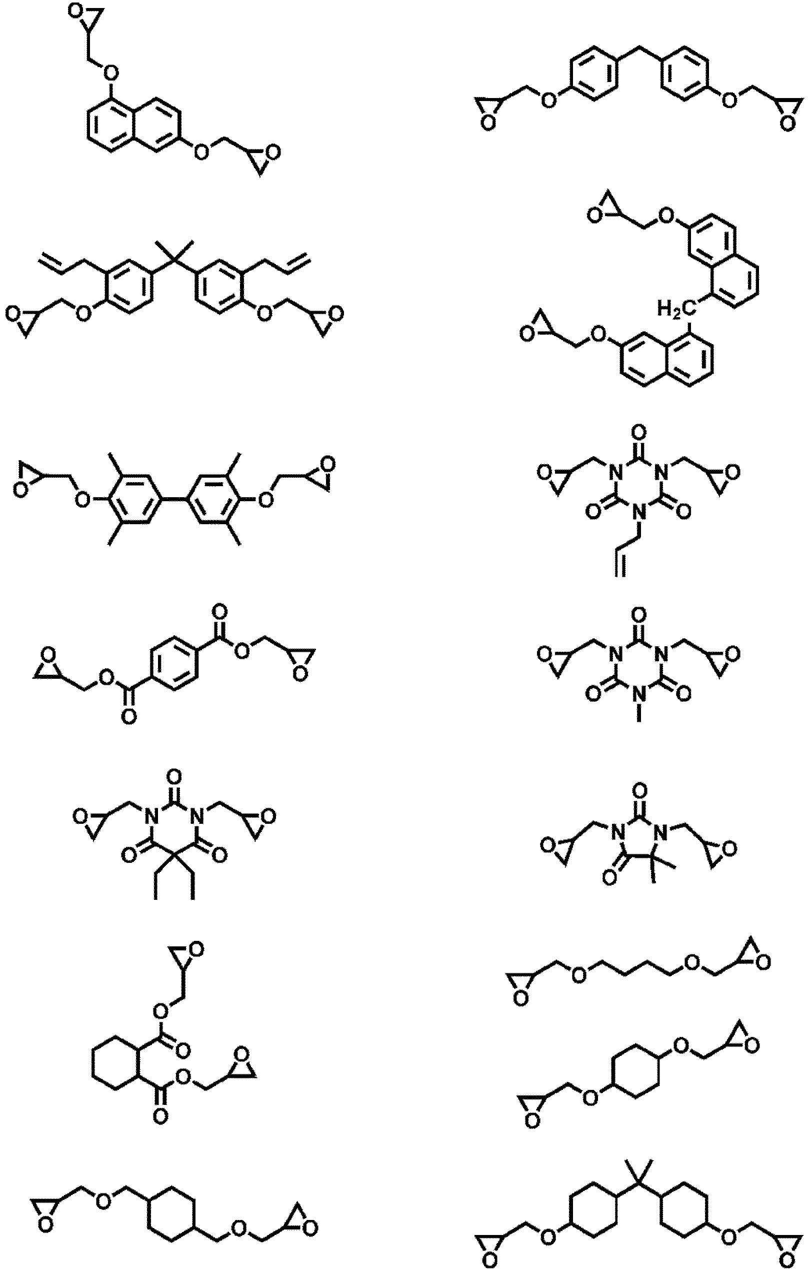

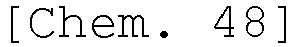

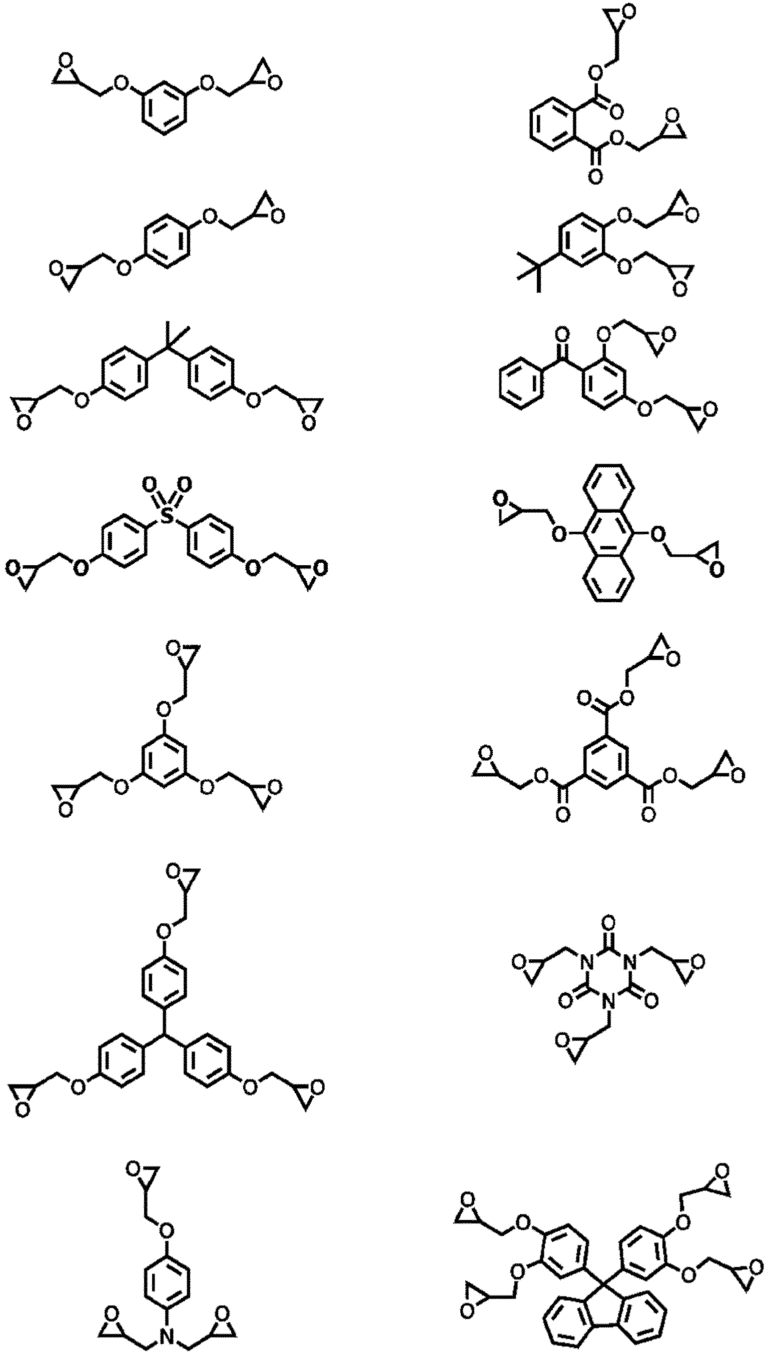

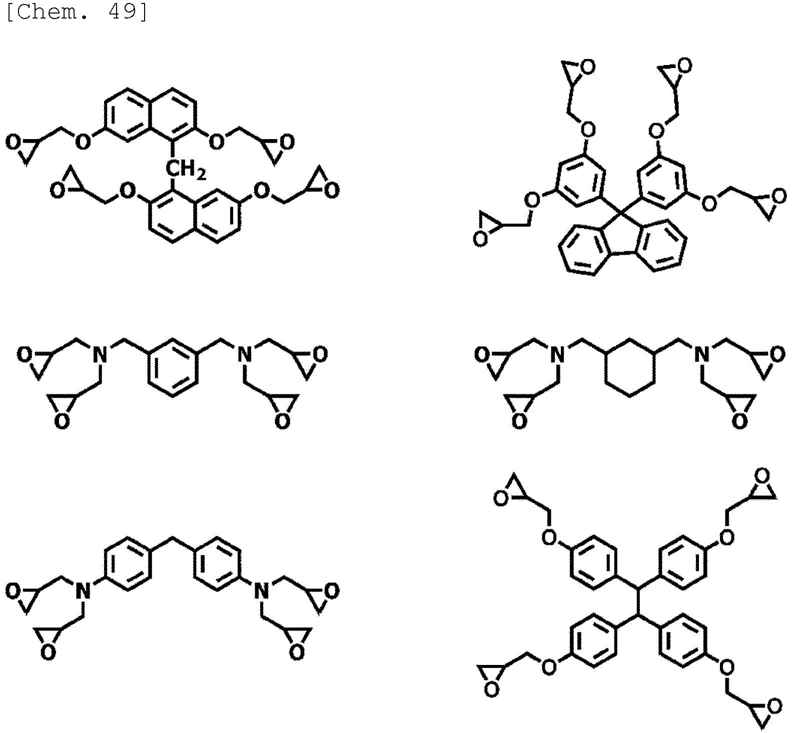

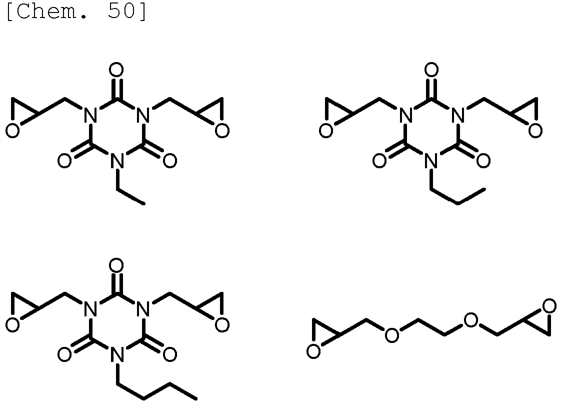

Examples of the compound represented by the formula (Y-2-1) and the compound represented by the formula (Y-2-2) include the following compounds:

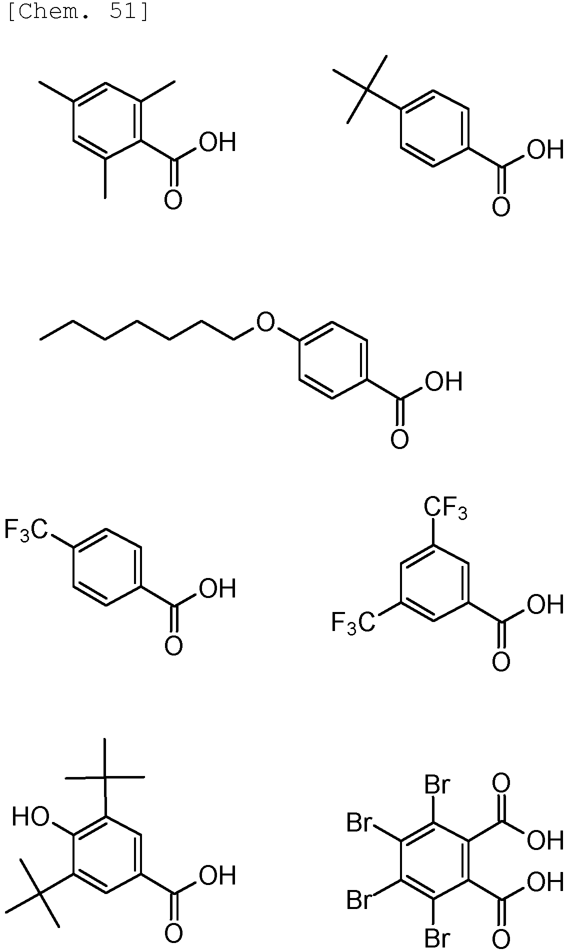

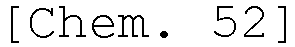

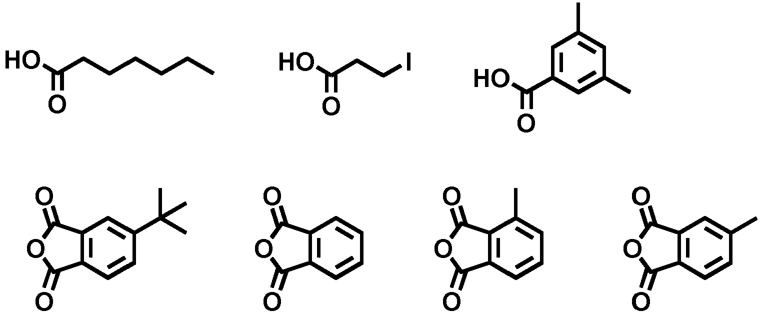

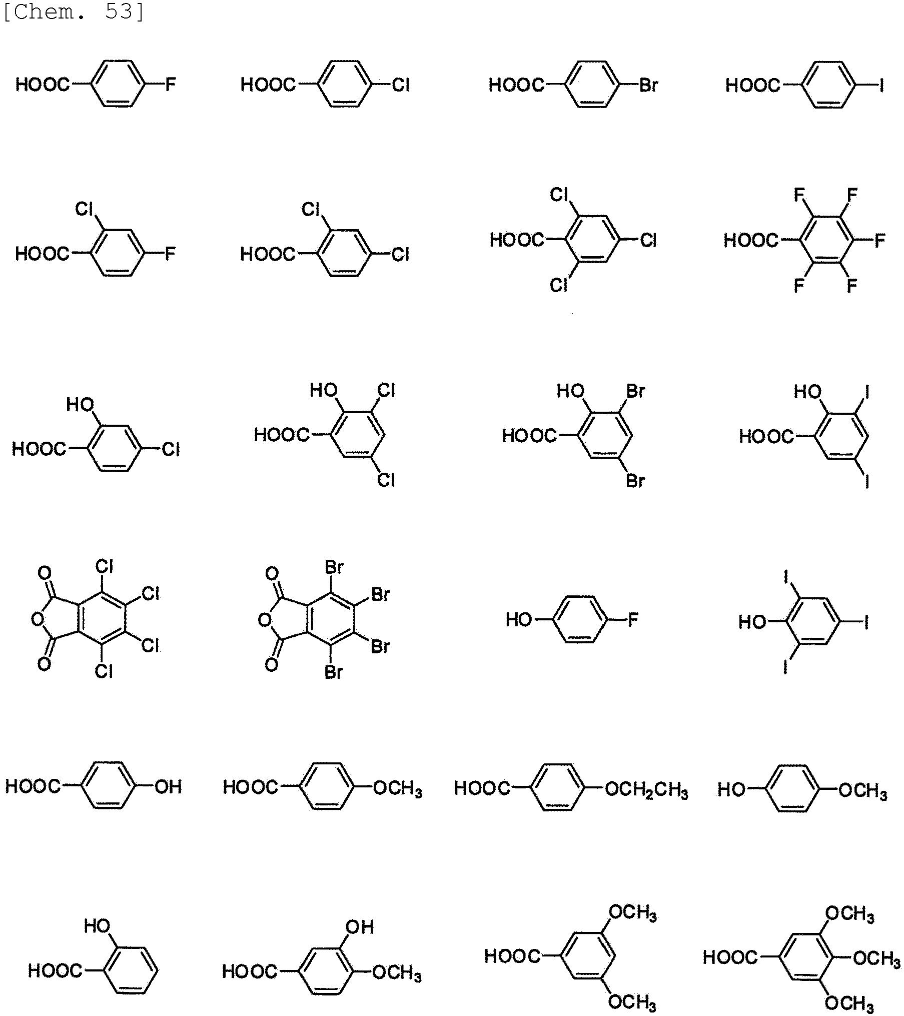

Note that if the compound represented by the formula (Y-2-1) has two or more carboxy groups, at least one carboxy group in the compound represented by the formula (Y-2-1) may be capped with a solvent when reacting the compound represented by the formula (Y-1) with the compound represented by the formula (Y-2-1) below. Examples of the solvent used for capping include alkylene glycol monoalkyl ether.

The molecular weight of the compound (B) is not particularly limited, and is preferably 500 to 3,000.

It is preferable that the molecular weight of the compound (B) is smaller than the weight average molecular weight of the polymer (A).

The content of the compound (B) in the resist underlayer film-forming composition is not particularly limited, but is preferably 1 mass% to 40 mass%, more preferably 2 mass% to 30 mass%, and particularly preferably 5 mass% to 20 mass% based on the polymer (A) from the viewpoint of suitably obtaining the effect of the present invention.

When the resist underlayer film-forming composition contains a crosslinking agent (D), the content of the compound (B) in the resist underlayer film-forming composition is not particularly limited, but is preferably 3 mass% to 100 mass%, more preferably 5 mass% to 75 mass%, and particularly preferably 10 mass% to 50 mass% based on the crosslinking agent (D).

### <Solvent (C)>

The solvent (C) is not particularly limited, and may be water or an organic solvent.

Examples of the organic solvent include alkylene glycol alkyl ether or a monocarboxylic acid ester of alkylene glycol monoalkyl ether.

Examples of the alkylene group of the alkylene glycol monoalkyl ether include a C₂₋₄ alkylene group.

Examples of the alkyl group of the alkylene glycol monoalkyl ether include a C₁₋₄ alkyl group.

The number of carbon atoms of the alkylene glycol monoalkyl ether is, for example, from 3 to 8.

Examples of the alkylene glycol monoalkyl ether include ethylene glycol monomethyl ether, ethylene glycol monoethyl ether, propylene glycol monomethyl ether, or propylene glycol monoethyl ether.

Examples of the alkylene group of the monocarboxylic acid ester of alkylene glycol monoalkyl ether include a C₂₋₄ alkylene group.

Examples of the alkyl group of the monocarboxylic acid ester of alkylene glycol monoalkyl ether include a C₁₋₄ alkyl group.

Examples of the monocarboxylic acid of the monocarboxylic acid ester of alkylene glycol monoalkyl ether include a saturated C₂₋₄ monocarboxylic acid.

Examples of the saturated C₂₋₄ monocarboxylic acid include acetic acid, propionic acid, or butyric acid.

The number of carbon atoms of the monocarboxylic acid ester of alkylene glycol monoalkyl ether is, for example, from 5 to 10.

Examples of the monocarboxylic acid ester of alkylene glycol monoalkyl ether include methyl cellosolve acetate, ethyl cellosolve acetate, propylene glycol monomethyl ether acetate, or propylene glycol propyl ether acetate.

Examples of the other organic solvent include diethylene glycol monomethyl ether, diethylene glycol monoethyl ether, propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, or N,N-dimethylacetamide.

Among these solvents (C), alkylene glycol monoalkyl ether or a monocarboxylic acid ester of alkylene glycol monoalkyl ether is preferable.

One kind of these solvents (C) can be used singly or two or more kinds thereof may be used in combination.

The mass ratio of the organic solvent in the solvent (C) is not particularly limited, but is preferably 50 mass% to 100 mass%.

The content of the solvent (C) in the resist underlayer film-forming composition is not particularly limited, but is preferably 50 mass% to 99.99 mass%, more preferably 75 mass% to 99.95 mass%, and particularly preferably 90 mass% to 99.9 mass%.

### <Crosslinking Agent (D)>

The crosslinking agent (D) is not particularly limited.

The crosslinking agent (D) has a structure different from those of the polymer (A) and the compound (B).

As the crosslinking agent (D), an aminoplast crosslinking agent or a phenoplast crosslinking agent is preferable.

The aminoplast crosslinking agent is a condensation adduct of a compound having an amino group (e.g., melamine, guanamine) and formaldehyde.

The phenoplast crosslinking agent is a condensation adduct of a compound having a phenolic hydroxy group and formaldehyde.

Examples of the crosslinking agent (D) include compounds having two or more of the following structures. 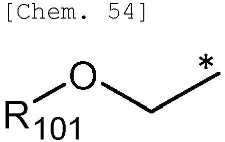 wherein in the structure, R₁₀₁ represents a hydrogen atom, a C₁₋₄ alkyl group, or a C₂₋₆ alkoxyalkyl group, and * represents a bond.

The bond is bonded to, for example, a nitrogen atom or a carbon atom constituting an aromatic hydrocarbon ring.

As R₁₀₁, a hydrogen atom, a methyl group, an ethyl group, or a group represented by the following structure is preferred. 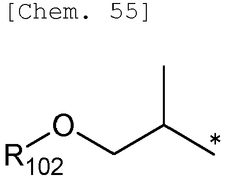 wherein in the structure, R₁₀₂ represents a hydrogen atom, a methyl group, or an ethyl group and * represents a bond.

The crosslinking agent (D) is preferably a melamine compound, a guanamine compound, a glycoluril compound, a urea compound, or a compound having a phenolic hydroxy group. One kind of these compounds may be used singly or two or more kinds thereof may be used in combination.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by the following formula (1E): 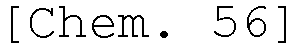 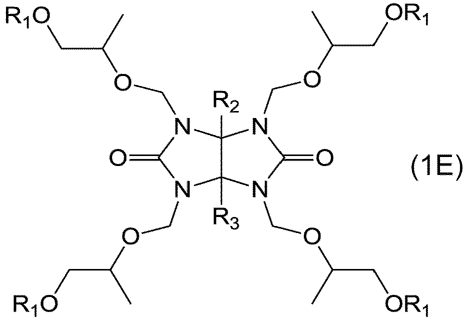 wherein in the formula (1E), four R₁ moieties each independently represent a methyl group or an ethyl group, and R₂ and R₃ each independently represent a hydrogen atom, a C₁₋₄ alkyl group, or a phenyl group.

Examples of the glycoluril derivative represented by formula (1E) include compounds represented by formulas (1E-1) to (1E-6) described below.

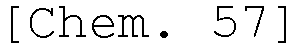

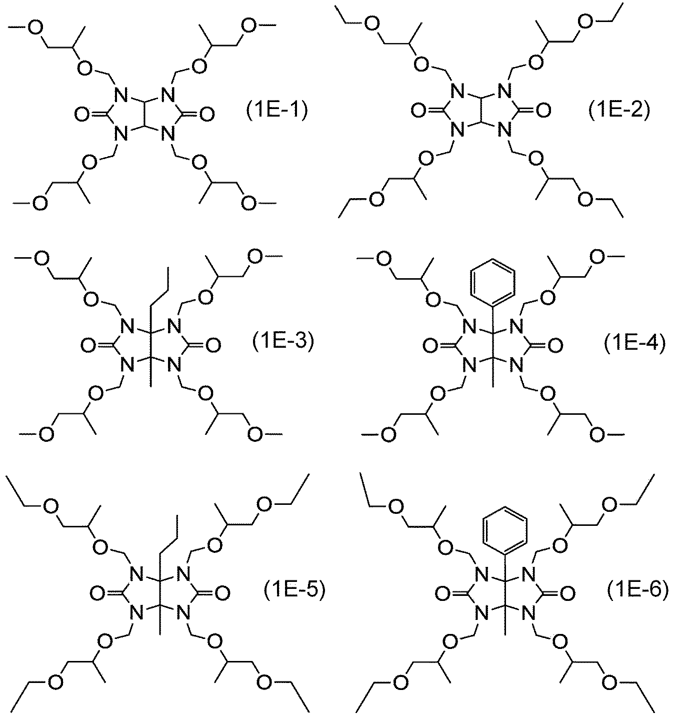

The glycoluril derivative represented by formula (1E) is prepared by reacting a glycoluril derivative represented by the following formula (2E) with at least one compound represented by the following formula (3d): 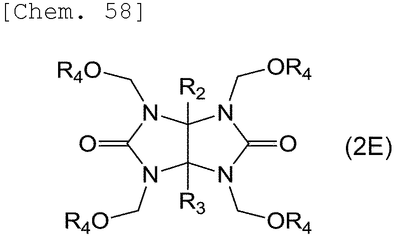 wherein in the formula (2E), R₂ and R₃ each independently represent a hydrogen atom, a C₁₋₄ alkyl group, or a phenyl group, and R₄ moieties each independently represent a C₁₋₄ alkyl group. 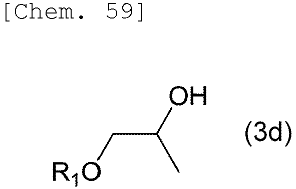 wherein in the formula (3d), R₁ represents a methyl group or an ethyl group.

Examples of the glycoluril derivative represented by formula (2E) include compounds represented by formulas (2E-1) to (2E-4) described below. Examples of the compound represented by Formula (3d) include compounds represented by Formulas (3d-1) and (3d-2) described below.

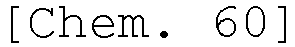

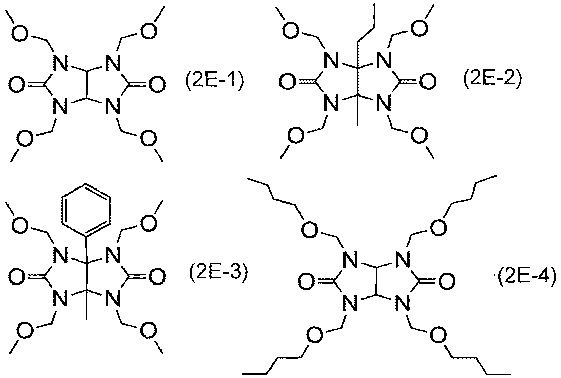

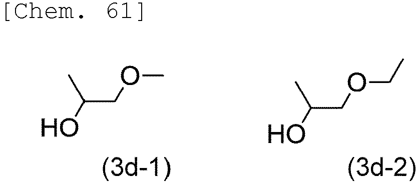

Examples of the urea compound include tetramethylol urea, tetramethoxy methyl urea, a compound in which 1 to 4 methylol groups of tetramethylol urea are methoxymethylated or a mixture thereof, and tetramethoxy ethyl urea.

Examples of the compound having a phenolic hydroxy group include compounds represented by the following formula (G-1) or formula (G-2): 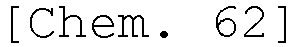 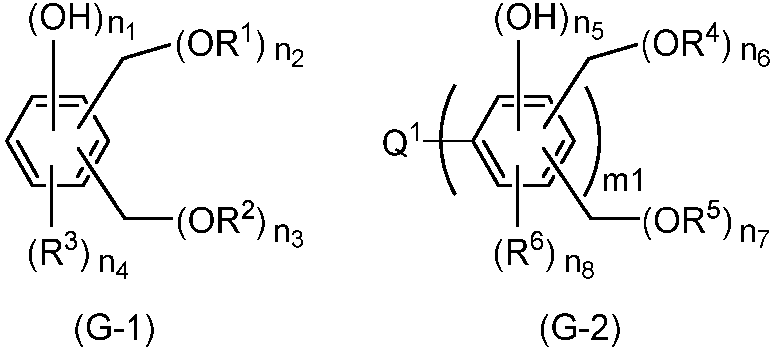
wherein in the formulas (G-1) and (G-2), Q¹ represents a single bond or an m1-valent organic group;
R¹ and R⁴ each represent a C₂₋₁₀ alkyl group or a C₂₋₁₀ alkyl group having a C₁₋₁₀ alkoxy group;
R² and R⁵ each represent a hydrogen atom or a methyl group;
R³ and R⁶ each represent a C₁₋₁₀ alkyl group or a C₆₋₄₀ aryl group;
n₁ represents an integer of 1 ≤ n₁ ≤ 3, n₂ represents an integer of 2 ≤ n₂ ≤ 5, n₃ represents an integer of 0 ≤ n₃ ≤ 3, and n₄ represents an integer of 0 ≤ n₄ ≤ 3, and the integers meet 3 ≤ (n₁ + n₂ + n₃ + n₄) ≤ 6;
n₅ represents an integer of 1 ≤ n₅ ≤ 3, n₆ represents an integer of 1 ≤ n₆ ≤ 4, n₇ represents an integer of 0 ≤ n₇ ≤ 3, and n₈ represents an integer of 0 ≤ n₈ ≤ 3, and the integers meet 2 ≤ (n₅ + n₆ + n₇ + n₈) ≤ 5; and
m1 represents an integer of 2 to 10.

In addition, examples of the compound having a phenolic hydroxy group include compounds represented by formula (G-3) or formula (G-4) below.

The compound represented by formula (G-1) or (G-2) may be obtained by reacting a compound represented by formula (G-3) or (G-4) described below with a hydroxyl group-containing ether compound or a C₂₋₁₀ alcohol. 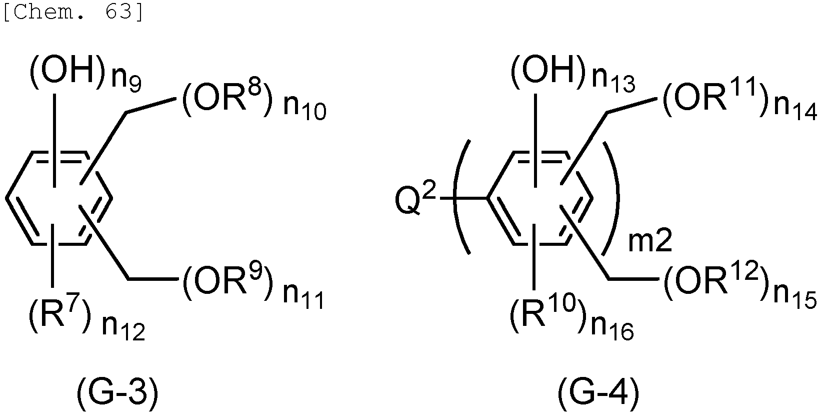
wherein in formulas (G-3) and (G-4), Q² represents a single bond or an m2-valent organic group;
R⁸, R⁹, R¹¹, and R¹² each represent a hydrogen atom or a methyl group;
R⁷ and R¹⁰ each represent a C₁₋₁₀ alkyl group or a C₆₋₄₀ aryl group;
n₉ represents an integer of 1 ≤ n₉ ≤ 3, n₁₀ represents an integer of 2 ≤ n₁₀ ≤ 5, n₁₁ represents an integer of 0 ≤ n₁₁ ≤ 3, and n₁₂ represents an integer of 0 ≤ n₁₂ ≤ 3, and the integers meet 3 ≤ (n₉ + n₁₀ + n₁₁ + n₁₂) ≤ 6;
n₁₃ represents an integer of 1 ≤ n₁₃ ≤ 3, n₁₄ represents an integer of 1 ≤ n₁₄ ≤ 4, n₁₅ represents an integer of 0 ≤ n₁₅ ≤ 3, and n₁₆ represents an integer of 0 ≤ n₁₆ ≤ 3, and the integers meet 2 ≤ (n₁₃ + n₁₄ + n₁₅ + n₁₆) ≤ 5; and
m2 represents an integer of 2 to 10.

Examples of the m2-valent organic group in Q² include an m2-valent C₁₋₄ organic group.

Examples of the compound represented by formula (G-1) or (G-2) include the following compounds:

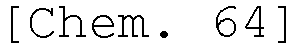

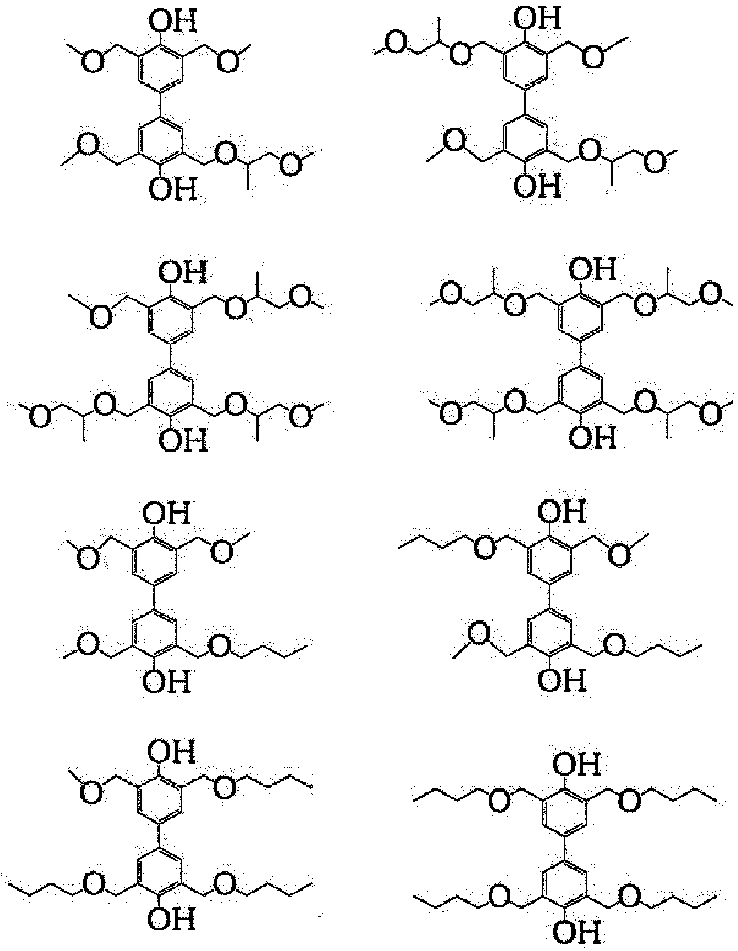

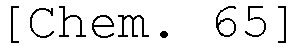

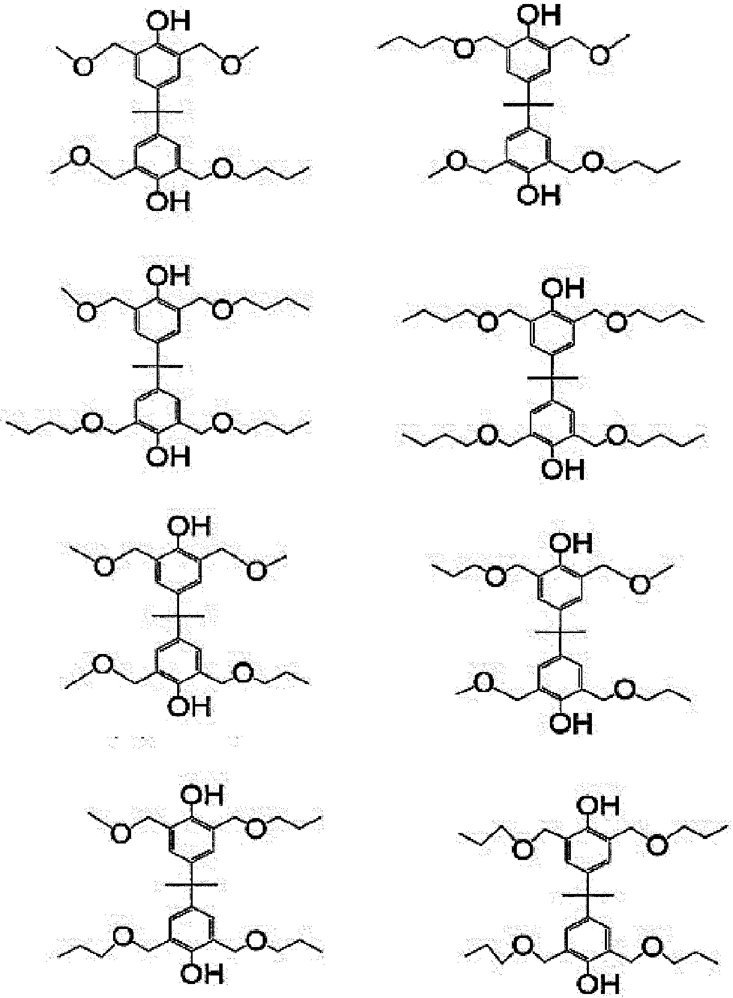

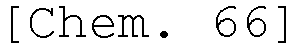

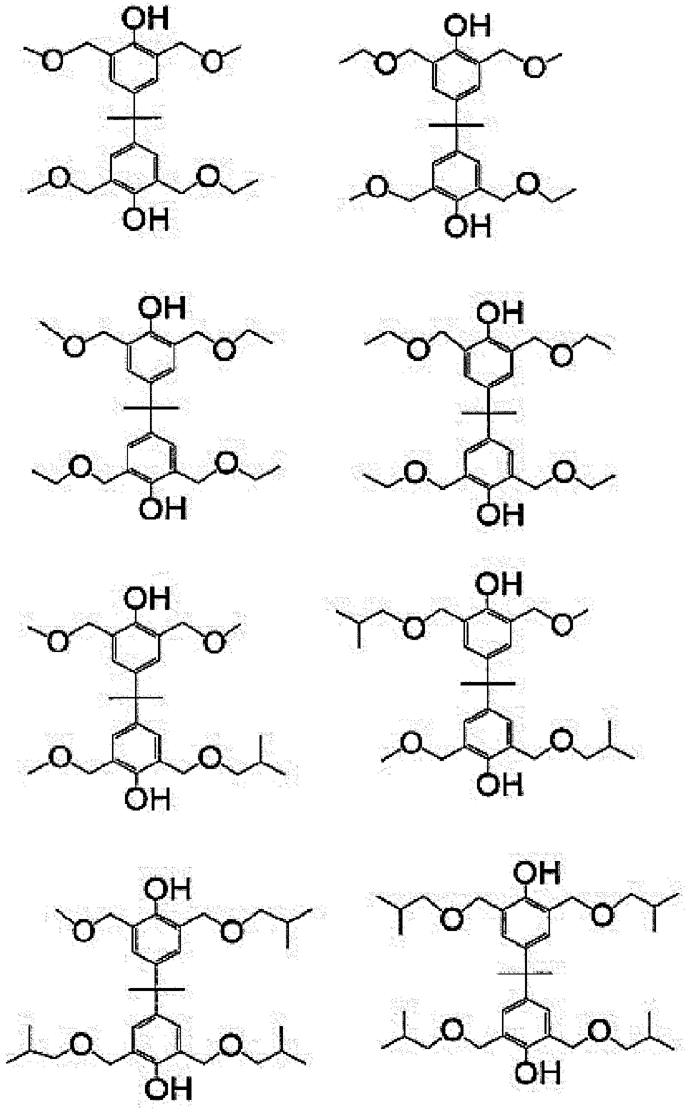

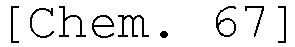

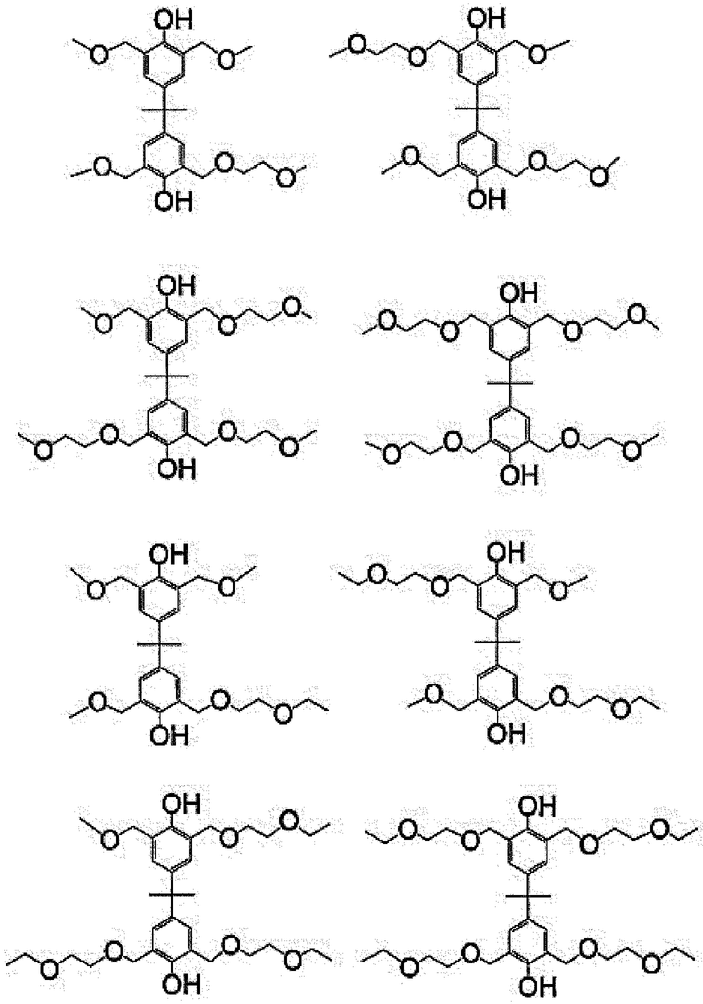

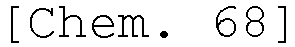

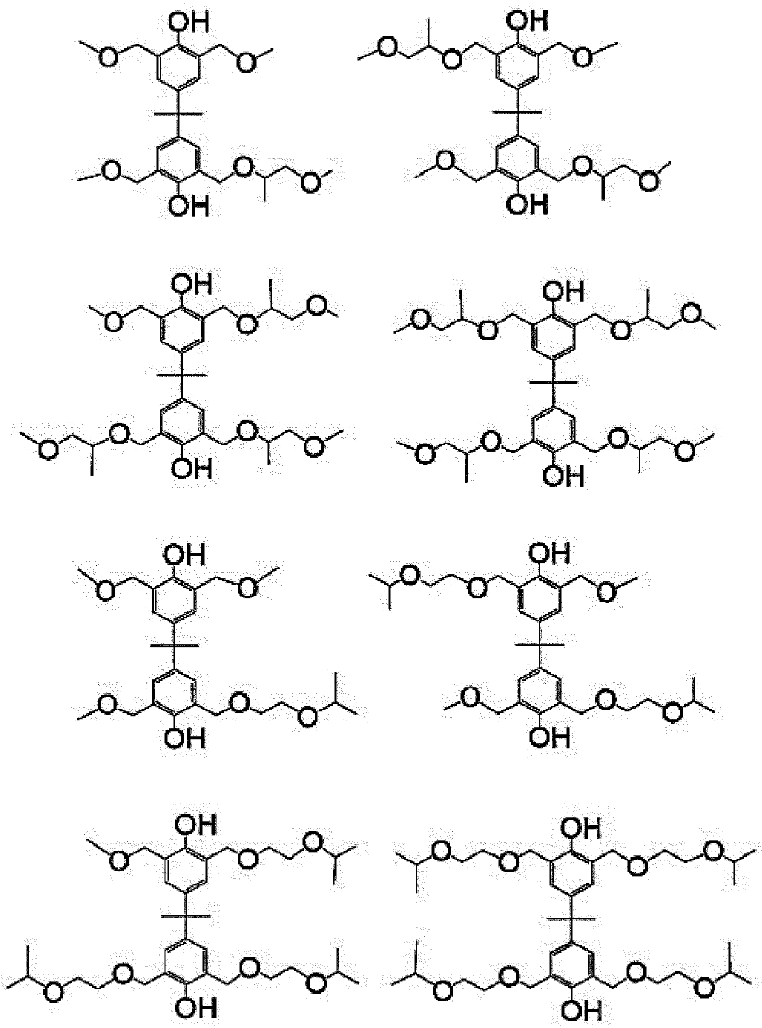

Examples of the compound represented by formula (G-3) or (G-4) include the following compounds:

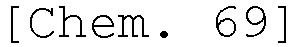

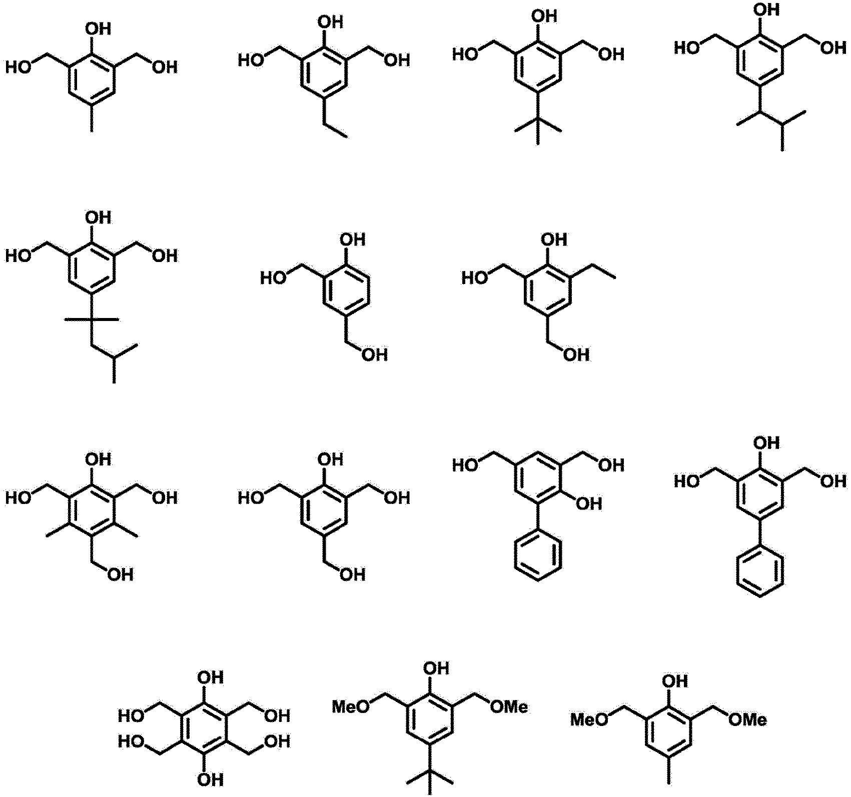

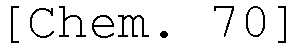

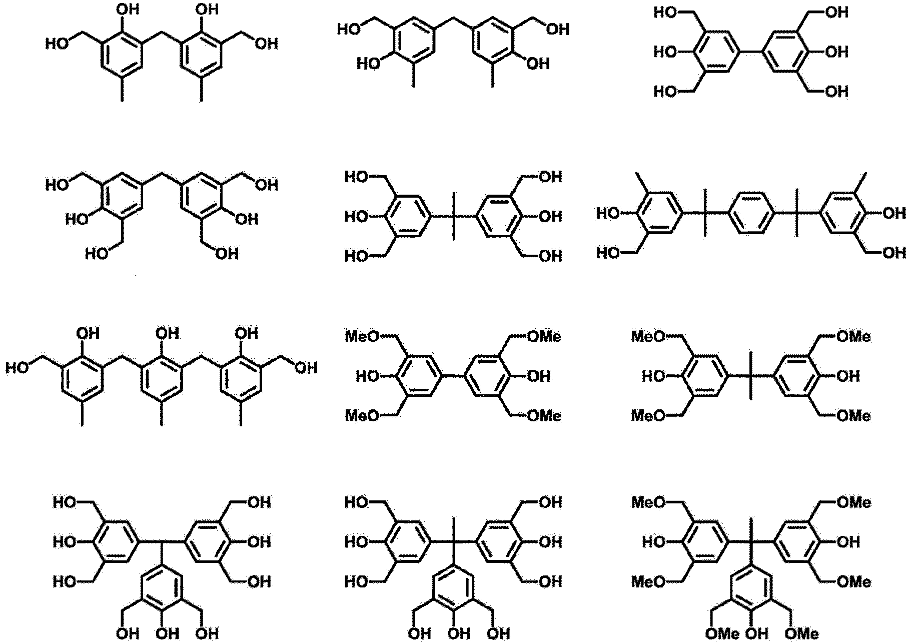

The compounds are available as products of Asahi Organic Chemicals Industry Co., Ltd. and Honshu Chemical Industry Co., Ltd. Examples of the products include TMOM-BP (trade name) manufactured by Asahi Organic Chemicals Industry Co., Ltd.

Among the compounds, the glycoluril compound is preferred. Specifically, tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof are preferred, and tetramethoxymethylglycoluril is more preferred.

The molecular weight of the crosslinking agent (D) is not particularly limited, and is preferably 500 or less.

The content of the crosslinking agent (D) in the resist underlayer film-forming composition is not particularly limited, and is, for example, 1 mass% to 50 mass%, and preferably 5 mass% to 40 mass% based on the polymer (A).

### <Curing Catalyst (E)>

As the curing catalyst (E) included as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenol sulfonic acid, pyridinium-p-hydroxybenzenesulfonic acid (pyridinium p-phenolsulfonic acid salt), pyridinium-trifluoromethanesulfonic acid, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine-p-toluenesulfonic acid, N-methylmorpholine-p-hydroxybenzenesulfonic acid, and N-methylmorpholine-5-sulfosalicylic acid.

Examples of the photoacid generator include onium salt compounds, sulfonimide compounds, and disulfonyldiazomethane compounds.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compounds include N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

Only one kind of curing catalyst (E) may be used, or two or more kinds thereof may be used in combination.

In the case of using the curing catalyst (E), the content ratio of the curing catalyst (E) is, for example, 0.1 mass% to 50 mass%, and preferably 1 mass% to 30 mass% based on the crosslinking agent (D).

### <Another Component>

To the resist underlayer film-forming composition, a surfactant can be further added in order to further improve the coating property against surface unevenness without generating a pinhole, a striation, and the like.

Examples of the surfactant include polyoxyethylene alkyl ethers such as polyoxyethylene lauryl ether, polyoxyethylene stearyl ether, polyoxyethylene cetyl ether, and polyoxyethylene oleyl ether, polyoxyethylene alkyl aryl ethers such as polyoxyethylene octylphenol ether and polyoxyethylene nonylphenol ether, polyoxyethylene/polyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, nonion-based surfactants of polyoxyethylene sorbitan fatty acid esters and the like such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine-based surfactants such as EFTOP EF301, EF303, and EF352 (manufactured by TOHKEM PRODUCTS Corporation, trade names), MEGAFACE F171, F173, and R-30 (manufactured by DIC Corporation, trade names), Fluorad FC430 and FC431 (manufactured by Sumitomo 3M Limited, trade names), AsahiGuard AG710 and Surflon S-382, SC101, SC102, SC103, SC104, SC105, and SC106 (manufactured by AGC Inc., trade names), and organosiloxane polymer KP341 (manufactured by Shin-Etsu Chemical Co., Ltd.).

The amount of each of these surfactants added is ordinarily 2.0 mass% or less, and preferably 1.0 mass% or less based on the total solid content of the resist underlayer film-forming composition.

These surfactants may be added singly, or may be added in combination of two or more thereof.

The amount of the solid content in the resist underlayer film-forming composition of the present invention, i.e., the components excluding the solvent is, for example, 0.01 mass% to 10 mass%.

The water contact angle of the resist underlayer film formed from the resist underlayer film-forming composition is, for example, 40° to 80°, 45° to 75°, or 50° to 70°.

The resist underlayer film is, for example, a resist underlayer film having a film thickness of 5 nm when the resist underlayer film-forming composition is applied onto a silicon wafer and then baked at 205°C for 60 seconds.

The water contact angle may be determined by a droplet method using, for example, a fully automatic contact angle meter DM-701 (manufactured by Kyowa Interface Science Co., Ltd.) .

### (Resist Underlayer Film)

A resist underlayer of the present invention is a cured product of the above-described resist underlayer film-forming composition.

The resist underlayer film can be produced, for example, by applying the above-described resist underlayer film-forming composition onto a semiconductor substrate and baking the composition.

Examples of the semiconductor substrate onto which the resist underlayer film-forming composition is applied include silicon wafers, germanium wafers, and compound semiconductor wafers of gallium arsenide, indium phosphide, gallium nitride, indium nitride, aluminum nitride, and the like.

In the case of using a semiconductor substrate having a surface on which an inorganic film is formed, the inorganic film is formed with, for example, an atomic layer deposition (ALD) method, a chemical vapor deposition (CVD) method, a reactive sputtering method, an ion plating method, a vacuum deposition method, or a spin coating method (spin-on-glass: SOG). Examples of the inorganic film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film.

The resist underlayer film-forming composition of the present invention is applied onto such a semiconductor substrate with an appropriate application method using a spinner, a coater, or the like. Then, the composition is baked using a heating unit such as a hot plate to form a resist underlayer film. The baking conditions are appropriately selected from a baking temperature of 100°C to 400°C and a baking time of 0.3 minutes to 60 minutes. It is preferable that the baking temperature be 120°C to 350°C and the baking time be 0.5 minutes to 30 minutes, and it is more preferable that the baking temperature be 150°C to 300°C and the baking time be 0.8 minutes to 10 minutes.

The water contact angle of the resist underlayer film is, for example, 40° to 80°, 45° to 75°, or 50° to 70°.

The water contact angle may be determined by a droplet method using, for example, a fully automatic contact angle meter DM-701 (manufactured by Kyowa Interface Science Co., Ltd.) .

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

The method for measuring the film thickness of the resist underlayer film in the present specification is as follows.
·Measurement apparatus name: Ellipsometric Film Thickness Measurement System RE-3100 (SCREEN Semiconductor Solutions Co., Ltd.)
·Single wavelength ellipsometer (SWE) mode
·Arithmetic average of eight points (e.g. eight points are measured at intervals of 1 cm in the X direction of the wafer.)

### (Laminate)

The laminate of the present invention includes a semiconductor substrate and the resist underlayer film of the present invention.

Examples of the semiconductor substrate include the semiconductor substrates described above.

The resist underlayer film is disposed, for example, on the semiconductor substrate.

### (Method for Producing Semiconductor Element and Method of Forming Pattern)

The method for producing a semiconductor element according to the present invention includes at least the following steps:
· a step of forming a resist underlayer film on a semiconductor substrate by using the resist underlayer film-forming composition of the present invention, and
· a step of forming a resist film on the resist underlayer film.

The method of forming a pattern of the present invention includes at least the following steps:
· a step of forming a resist underlayer film on a semiconductor substrate by using the resist underlayer film-forming composition of the present invention;
· a step of forming a resist film on the resist underlayer film;
· a step of irradiating the resist film with light or an electron beam and then developing the resist film to obtain a resist pattern; and
· a step of etching the resist underlayer film using the resist pattern as a mask.

Ordinarily, a resist layer is formed on the resist underlayer film.

The film thickness of the resist layer is preferably 200 nm or less, more preferably 150 nm or less, still more preferably 100 nm or less, and particularly preferably 80 nm or less. The film thickness of the resist layer is preferably 10 nm or more, more preferably 20 nm or more, and particularly preferably 30 nm or more.

The resist formed on the resist underlayer film with a known method (such as application and baking of a resist composition) is not particularly limited as long as it responds to light or an electron beam (EB) used for irradiation. Both a negative photoresist and a positive photoresist can be used.

In the present specification, a resist responding to EB is also referred to as a photoresist.

Examples of the photoresist include a positive photoresist including a novolac resin and 1,2-naphthoquinone diazide sulfonic acid ester, a chemically amplified photoresist including a binder having a group that is decomposed by an acid to increase the alkali dissolution rate and a photoacid generator, a chemically amplified photoresist including a low-molecular compound that is decomposed by an acid to increase the alkali dissolution rate of a photoresist, an alkali-soluble binder, and a photoacid generator, a chemically amplified photoresist including a binder having a group that is decomposed by an acid to increase the alkali dissolution rate, a low-molecular compound that is decomposed by an acid to increase the alkali dissolution rate of a photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Furthermore, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

Furthermore, so-called resist compositions and metal-containing resist compositions can be used that include resist compositions, radiation-sensitive resin compositions, and high-resolution patterning compositions based on organometallic solutions, described in WO 2019/188595, WO 2019/187881, WO 2019/187803, WO 2019/167737, WO 2019/167725, WO 2019/187445, WO 2019/167419, WO 2019/123842, WO 2019/054282, WO 2019/058945, WO 2019/058890, WO 2019/039290, WO 2019/044259, WO 2019/044231, WO 2019/026549, WO 2018/193954, WO 2019/172054, WO 2019/021975, WO 2018/230334, WO 2018/194123, JP 2018-180525, WO 2018/190088, JP 2018-070596, JP 2018-028090, JP 2016-153409, JP 2016-130240, JP 2016-108325, JP 2016-047920, JP 2016-035570, JP 2016-035567, JP 2016-035565, JP 2019-101417, JP 2019-117373, JP 2019-052294, JP 2019-008280, JP 2019-008279, JP 2019-003176, JP 2019-003175, JP 2018-197853, JP 2019-191298, JP 2019-061217, JP 2018-045152, JP 2018-022039, JP 2016-090441, JP 2015-10878, JP 2012-168279, JP 2012-022261, JP 2012-022258, JP 2011-043749, JP 2010-181857, JP 2010-128369, WO 2018/031896, JP 2019-113855, WO 2017/156388, WO 2017/066319, JP 2018-41099, WO 2016/065120, WO 2015/026482, JP 2016-29498, JP 2011-253185, and the like, but the resist compositions are not limited thereto.

Examples of the resist composition include the following compositions.

An active ray-sensitive or radiation-sensitive resin composition containing: a resin A having a repeating unit having an acid-decomposable group in which a polar group is protected by a protecting group that is removed by an action of an acid; and a compound represented by the following formula (121): 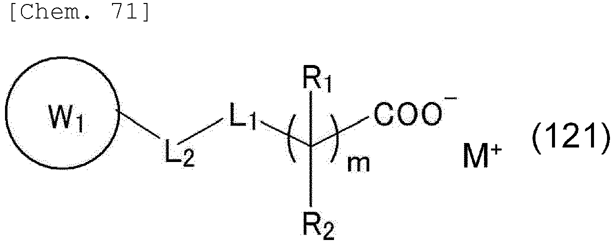
wherein in formula (121), m represents an integer of 1 to 6,
R₁ and R₂ each independently represent a fluorine atom or a perfluoroalkyl group,
L₁ represents -O-, -S-, -COO-, -SO₂-, or -SO₃-,
L₂ represents an alkylene group optionally having a substituent, or a single bond,
W₁ represents a cyclic organic group optionally having a substituent, and
M⁺ represents a cation.

A metal-containing film-forming composition for extreme ultraviolet or electron beam lithography, including: a compound having a metal-oxygen covalent bond; and a solvent, wherein a metal element included in the compound belongs to the third to seventh periods of Groups 3 to 15 of the periodic table.

A radiation-sensitive resin composition including: a polymer having a first structural unit represented by formula (31) described below and a second structural unit represented by formula (32) described below and containing an acid-dissociable group; and an acid generator. 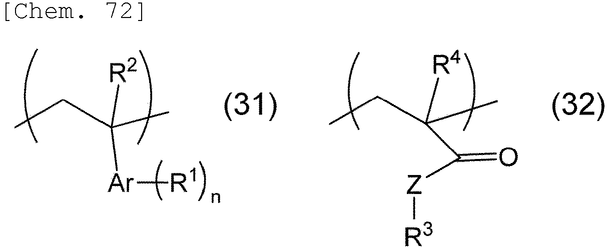 wherein in formula (31), Ar represents a group obtained by removing (n+1) hydrogen atoms from a C₆₋₂₀ arene, R¹ represents a hydroxy group, a sulfanyl group, or a monovalent C₁₋₂₀ organic group, n is an integer of 0 to 11, when n is 2 or more, a plurality of R¹ moieties are the same or different, R² represents a hydrogen atom, a fluorine atom, a methyl group, or a trifluoromethyl group; and in formula (32), R³ represents a C₁₋₂₀ monovalent group containing the acid-dissociable group, Z represents a single bond, an oxygen atom, or a sulfur atom, and R⁴ represents a hydrogen atom, a fluorine atom, a methyl group, or a trifluoromethyl group.

A resist composition including: a resin (A1) including a structural unit having a cyclic carbonate structure, a structural unit represented by the following formula, and a structural unit having an acid-unstable group; and an acid generator. 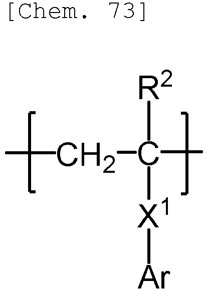 wherein in the formula,
R² represents a C₁₋₆ alkyl group optionally having a halogen atom or represents a hydrogen atom or a halogen atom, X¹ represents a single bond, -CO-O-*, or -CO-NR⁴-*, * represents a bond with -Ar, R⁴ represents a hydrogen atom or a C₁₋₄ alkyl group, and Ar represents a C₆₋₂₀ aromatic hydrocarbon group optionally having one or more moieties selected from the group consisting of a hydroxy group and a carboxyl group.

Examples of the resist film include the following.

A resist film including a base resin including a repeating unit represented by formula (a1) described below and/or a repeating unit represented by formula (a2) described below, and a repeating unit that generates a polymer main chain-bonded acid by exposure. 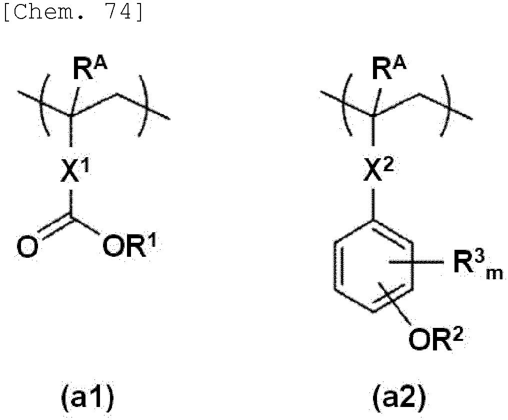 wherein in formulas (a1) and (a2), R^{A} moieties each independently represent a hydrogen atom or a methyl group, R¹ and R² each independently represent a C₄₋₆ tertiary alkyl group, R³ each independently represents a fluorine atom or a methyl group, m is an integer of 0 to 4, X¹ represents a single bond, a phenylene group, a naphthylene group, or a C₁₋₁₂ linking group including at least one selected from an ester bond, a lactone ring, a phenylene moiety, and a naphthylene moiety, and X² represents a single bond, an ester bond, or an amide bond.

Examples of a resist material include the following.

A resist material including a polymer having a repeating unit represented by formula (b1) or (b2) described below. 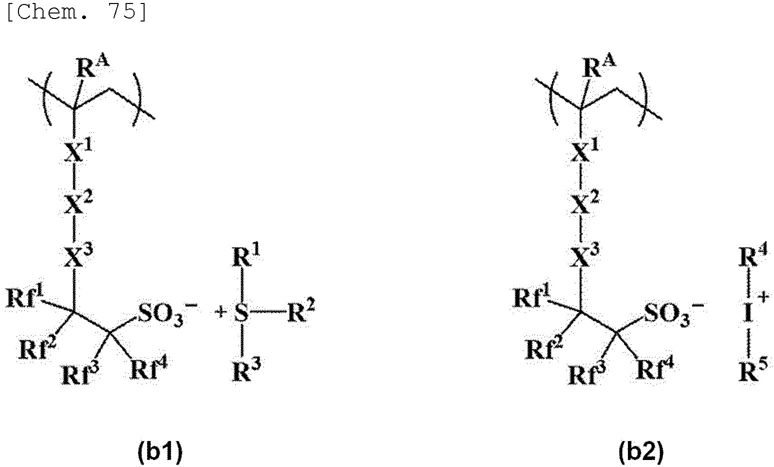 wherein in formulas (b1) and (b2), R^{A} represents a hydrogen atom or a methyl group; X¹ represents a single bond or an ester group; X² represents a linear, branched, or cyclic C₁₋₁₂ alkylene group or C₆₋₁₀ arylene group, and a part of a methylene moiety included in the alkylene group is optionally substituted with an ether moiety, an ester moiety, or a lactone ring-containing moiety, and at least one hydrogen atom included in X² is substituted with a bromine atom; X³ is a single bond, an ether group, an ester group, or a linear, branched, or cyclic C₁₋₁₂ alkylene group, and a part of a methylene moiety included in the alkylene group is optionally substituted with an ether moiety or an ester moiety; Rf¹ to Rf⁴ each independently represent a hydrogen atom, a fluorine atom, or a trifluoromethyl group, and at least one of Rf¹ to Rf⁴ represents a fluorine atom or a trifluoromethyl group; alternatively, Rf¹ and Rf² are optionally combined to form a carbonyl group; R¹ to R⁵ each independently represent a linear, branched, or cyclic C₁₋₁₂ alkyl group, a linear, branched, or cyclic C₂₋₁₂ alkenyl group, a C₂₋₁₂ alkynyl group, a C₆₋₂₀ aryl group, a C₇₋₁₂ aralkyl group, or a C₇₋₁₂ aryloxyalkyl group, and some or all of hydrogen atoms of these groups are optionally substituted with a hydroxy moiety, a carboxy moiety, a halogen atom, an oxo moiety, a cyano moiety, an amide moiety, a nitro moiety, a sultone moiety, a sulfone moiety, or a sulfonium salt-containing moiety, and some of methylene moieties included in these groups are optionally substituted with an ether moiety, an ester moiety, a carbonyl moiety, a carbonate moiety, or a sulfonic acid ester moiety; and R¹ and R² are optionally bonded to form a ring together with a sulfur atom to which R¹ and R² are bonded.

A resist material containing a base resin containing a polymer including a repeating unit represented by formula (a) described below. 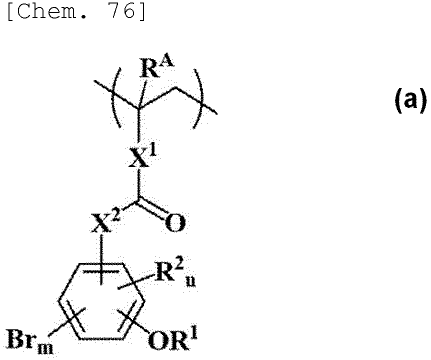 wherein in formula (a), R^{A} represents a hydrogen atom or a methyl group, R¹ represents a hydrogen atom or an acid-unstable group, R² represents a linear, branched, or cyclic C₁₋₆ alkyl group or a halogen atom other than bromine, X¹ represents a single bond, a phenylene group, or a linear, branched, or cyclic C₁₋₁₂ alkylene group optionally including an ester moiety or a lactone ring, X² represents -O-, -O-CH₂-, or -NH-, m is an integer of 1 to 4, and u is an integer of 0 to 3, provided that m + u is an integer of 1 to 4.

A resist composition that generates an acid by exposure to change in solubility due to an action of the acid in a developer,
the resist composition including: a base material component (A) that changes in solubility due to an acid of an acid in a developer; and a fluorine additive component (F) that exhibits decomposability in an alkaline developer,
the fluorine additive component (F) including a fluororesin component (F1) having a constituent unit (f1) including a base dissociable group and a constituent unit (f2) including a group represented by the following general formula (f2-r-1). 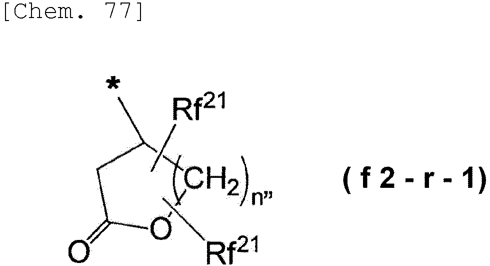
wherein in formula (f2-r-1), Rf²¹ moieties each independently represent a hydrogen atom, an alkyl group, an alkoxy group, a hydroxyl group, a hydroxyalkyl group, or a cyano group, n" is an integer of 0 to 2, and * represents a bond.

The constituent unit (f1) includes a constituent unit represented by the following general formula (f1-1) or a constituent unit represented by the following general formula (f1-2). 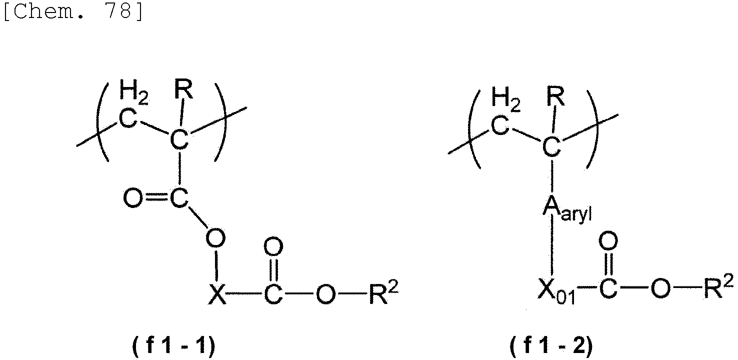 wherein in the formulas (f1-1) and (f1-2), R moieties each independently represent a hydrogen atom, a C₁₋₅ alkyl group, or a halogenated C₁₋₅ alkyl group, X represents a divalent linking group not having an acid-dissociable site, A_{aryl} represents a divalent aromatic cyclic group optionally having a substituent, X₀₁ represents a single bond or a divalent linking group, and R² moieties each independently represent an organic group having a fluorine atom.

Examples of a coating, a coating solution, and a coating composition include the following.

A coating including a metal oxo-hydroxo network having an organic ligand with a metal-carbon bond and/or a metal-carboxylate bond.

An inorganic oxo/hydroxo-based composition.

A coating solution including: an organic solvent; a first organometallic composition represented by the formula R_{z}SnO_{(2-(z/2)-(x/2))}(OH)ₓ (where 0 < z ≤ 2 and 0 < (z + x) ≤ 4), the formula R'ₙSnX₄₋ₙ (where n = 1 or 2), or a mixture thereof, wherein R and R' independently represent a C₁₋₃₁ hydrocarbyl group and X represents a ligand having a hydrolysable bond to Sn or a combination of such ligands; and a hydrolysable metal compound represented by the formula MX'ᵥ (where M represents a metal selected from Groups 2 to 16 of the periodic table, v is a number of v = 2 to 6, and X' represents a ligand having a hydrolysable M-X bond or a combination of such ligands).

A coating solution including an organic solvent and a first organometallic compound represented by the formula RSnO_{(3/2-x/2)}(OH)ₓ (where 0 < x < 3) wherein the solution contains about 0.0025 M to about 1.5 M tin, R represents an alkyl group or a C₃₋₃₁ cycloalkyl group, and the alkyl group or the cycloalkyl group is bonded to tin at a secondary or tertiary carbon atom.

An inorganic patterning precursor aqueous solution including a mixture of water, a metal suboxide cation, a polyatomic inorganic anion, and a radiation-sensitive ligand including a peroxide group.

Irradiation with light or an electron beam is performed, for example, through a mask (reticle) for formation of a predetermined pattern. For example, an i-ray, a KrF excimer laser, an ArF excimer laser, an extreme ultraviolet ray (EUV), or an electron beam (EB) is used. The resist underlayer film-forming composition of the present invention is preferably applied for electron beam (EB) irradiation or extreme ultraviolet ray ((EUV): 13.5 nm) irradiation, and more preferably applied for extreme ultraviolet ray (EUV) exposure.

The irradiation energy of the electron beam and the exposure amount of light are not particularly limited.

Post exposure bake (PEB) may be performed after irradiation with light or an electron beam and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

For the development, for example, an alkaline developer is used.

The developing temperature is, for example, 5°C to 50°C.

The developing time is, for example, 10 seconds to 300 seconds.

As the alkaline developer, for example, an aqueous solution of an alkali can be used, and examples of the alkali include inorganic alkalis such as sodium hydroxide, potassium hydroxide, sodium carbonate, sodium silicate, sodium metasilicate, and ammonia water, primary amines such as ethylamine and n-propylamine, secondary amines such as diethylamine and di-n-butylamine, tertiary amines such as triethylamine and methyldiethylamine, alcoholamines such as dimethylethanolamine and triethanolamine, quaternary ammonium salts such as tetramethylammonium hydroxide, tetraethylammonium hydroxide, and choline, and cyclic amines such as pyrrole and piperidine. Furthermore, an alcohol such as isopropyl alcohol, or a nonion-based surfactant can be added in an appropriate amount to the aqueous solution of an alkali and used. Among these developers, an aqueous solution of a quaternary ammonium salt is preferable, and an aqueous solution of tetramethylammonium hydroxide and an aqueous solution of choline are more preferable. Furthermore, a surfactant or the like can be added to these developers. A method can also be used in which an organic solvent such as butyl acetate is used in place of the alkaline developer for development to develop a portion where the alkali dissolution rate of the photoresist is not improved.

Next, the resist underlayer film is etched using the formed resist pattern as a mask. The etching may be dry etching or wet etching, and dry etching is preferable.

In a case where the inorganic film is formed on a surface of the used semiconductor substrate, a surface of the inorganic film is exposed, and in a case where the inorganic film is not formed on a surface of the used semiconductor substrate, a surface of the semiconductor substrate is exposed. Then, a semiconductor element can be produced through a step of processing the semiconductor substrate with a known method (dry etching method or the like).

### Examples

Next, the contents of the present invention will be specifically described with reference to Examples, but the present invention is not limited thereto.

### <To measure molecular weight>

The weight average molecular weights of the polymers shown in the following Synthesis Examples 1 to 10 and Comparative Synthesis Example 1 in the present specification are the measurement results by gel permeation chromatography (hereinafter, abbreviated as GPC). For the measurement, a GPC apparatus manufactured by Tosoh Corporation was used, and measurement conditions and the like are as follows:
·GPC column: TSKgel Super-Multipore HZ-N (two columns)
·Column temperature: 40°C
·Solvent: Tetrahydrofuran (THF)
·Flow rate: 0.35 mL/min
·Standard sample: Polystyrene (manufactured by Tosoh Corporation)

### <Synthesis Example 1>

First, 6.00 g of monoallyl diglycidyl isocyanuric acid (manufactured by Shikoku Chemicals Corporation), 4.76 g of 5-nitroisophthalic acid (manufactured by Tokyo Chemical Industry Co., Ltd.), and 0.55 g of tetrabutylphosphonium bromide (manufactured by Hokko Chemical Industry Co., Ltd.) were added to 45.68 g of propylene glycol monomethyl ether in a reaction vessel and dissolved. The reaction vessel was purged with nitrogen, and the mixture was then reacted at 140°C for 24 hours to prepare a solution containing a polymer 1. As a result of GPC analysis, the polymer 1 obtained had a weight average molecular weight of 5,400 in terms of standard polystyrene and a dispersity of 3.4. The structure present in the polymer 1 is represented by the following formula.

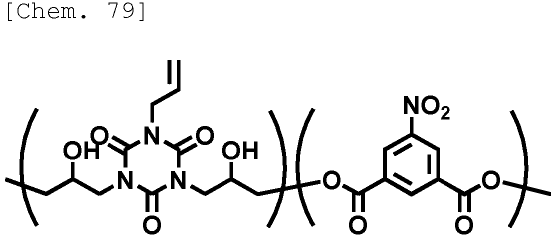

### <Synthesis Example 2>

First, 5.00 g of monoallyl diglycidyl isocyanuric acid (manufactured by Shikoku Chemicals Corporation), 3.39 g of 5-nitroisophthalic acid (manufactured by Tokyo Chemical Industry Co., Ltd.), 0.64 g of 4-tert-butylbenzoic acid (manufactured by Tokyo Chemical Industry Co., Ltd.), and 0.46 g of tetrabutylphosphonium bromide (manufactured by Hokko Chemical Industry Co., Ltd.) were added to 22.11 g of propylene glycol monomethyl ether in a reaction vessel and dissolved. The reaction vessel was purged with nitrogen, and the mixture was then reacted at 140°C for 24 hours to prepare a solution containing a polymer 2. As a result of GPC analysis, the polymer 2 obtained had a weight average molecular weight of 3,800 in terms of standard polystyrene and a dispersity of 2.5. The structure present in the polymer 2 is represented by the following formula.

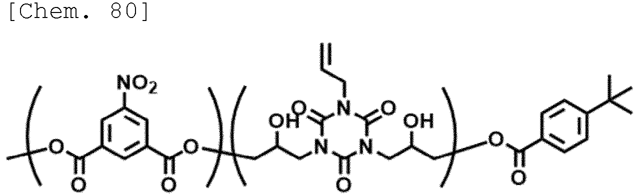

### <Synthesis Example 3>

First, 4.00 g of 1,3,5-tris (2,3-epoxypropyl)isocyanuric acid (trade name: TEPIC-SS, manufactured by Nissan Chemical Corporation), 6.65 g of 2,4,6-trimethylbenzoic acid (manufactured by Tokyo Chemical Industry Co., Ltd.), and 0.51 g of tetrabutylphosphonium bromide (manufactured by Hokko Chemical Industry Co., Ltd.) were added to 26.03 g of propylene glycol monomethyl ether in a reaction vessel and dissolved. The reaction vessel was purged with nitrogen, and the mixture was then reacted at 140°C for 24 hours to prepare a solution containing a polymer 3. As a result of GPC analysis, the polymer 3 obtained had a weight average molecular weight of 690 in terms of standard polystyrene and a dispersity of 1.0. The structure present in the polymer 3 is represented by the following formula.

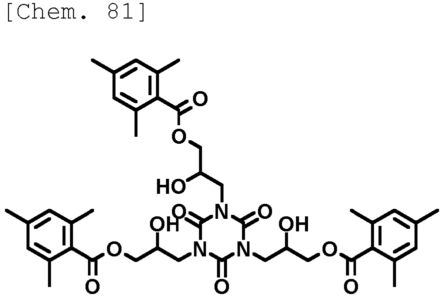

### <Synthesis Example 4>

First, 4.00 g of 1,3,5-tris (2,3-epoxypropyl)isocyanuric acid (trade name: TEPIC-SS, manufactured by Nissan Chemical Corporation), 7.22 g of 4-tert-butylbenzoic acid (manufactured by Tokyo Chemical Industry Co., Ltd.), and 0.51 g of tetrabutylphosphonium bromide (manufactured by Hokko Chemical Industry Co., Ltd.) were added to 27.36 g of propylene glycol monomethyl ether in a reaction vessel and dissolved. The reaction vessel was purged with nitrogen, and the mixture was then reacted at 140°C for 24 hours to prepare a solution containing a polymer 4. As a result of GPC analysis, the polymer 4 obtained had a weight average molecular weight of 910 in terms of standard polystyrene and a dispersity of 1.0. The structure present in the polymer 4 is represented by the following formula.

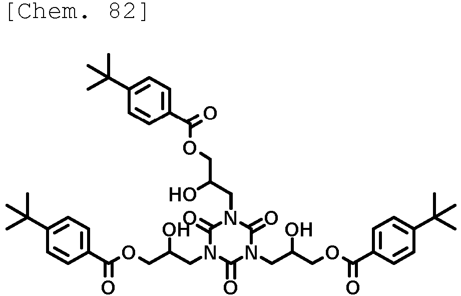

### <Synthesis Example 5>

First, 3.00 g of 1,3,5-tris (2,3-epoxypropyl)isocyanuric acid (trade name: TEPIC-SS, manufactured by Nissan Chemical Corporation), 7.11 g of 4-(heptyloxy)benzoic acid (manufactured by Tokyo Chemical Industry Co., Ltd.), and 0.38 g of tetrabutylphosphonium bromide (manufactured by Hokko Chemical Industry Co., Ltd.) were added to 24.49 g of propylene glycol monomethyl ether in a reaction vessel and dissolved. The reaction vessel was purged with nitrogen, and the mixture was then reacted at 140°C for 24 hours to prepare a solution containing a polymer 5. As a result of GPC analysis, the polymer 5 obtained had a weight average molecular weight of 1,200 in terms of standard polystyrene and a dispersity of 1.0. The structure present in the polymer 5 is represented by the following formula.

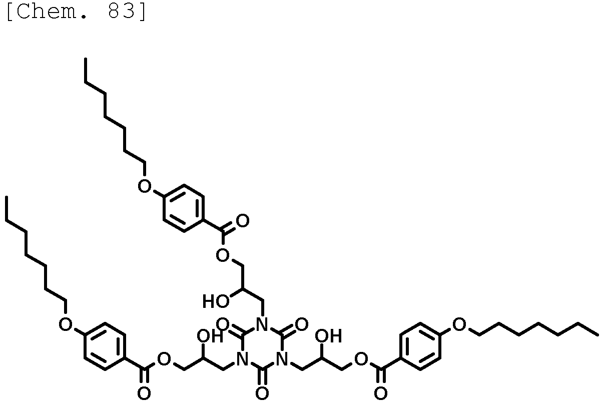

### <Synthesis Example 6>

First, 3.00 g of 1,3,5-tris (2,3-epoxypropyl)isocyanuric acid (trade name: TEPIC-SS, manufactured by Nissan Chemical Corporation), 5.77 g of 4-(trifluoromethyl)benzoic acid (manufactured by Tokyo Chemical Industry Co., Ltd.), and 0.38 g of tetrabutylphosphonium bromide (manufactured by Hokko Chemical Industry Co., Ltd.) were added to 21.36 g of propylene glycol monomethyl ether in a reaction vessel and dissolved. The reaction vessel was purged with nitrogen, and the mixture was then reacted at 140°C for 24 hours to prepare a solution containing a polymer 6. As a result of GPC analysis, the polymer 6 obtained had a weight average molecular weight of 890 in terms of standard polystyrene and a dispersity of 1.0. The structure present in the polymer 6 is represented by the following formula.

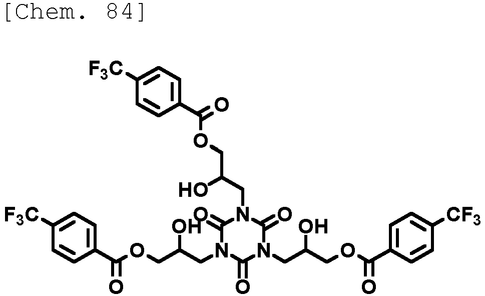

### <Synthesis Example 7>

First, 4.00 g of 1,3,5-tris (2,3-epoxypropyl)isocyanuric acid (trade name: TEPIC-SS, manufactured by Nissan Chemical Corporation), 10.45 g of 3,5-bis(trifluoromethyl)benzoic acid (manufactured by Tokyo Chemical Industry Co., Ltd.), and 0.51 g of tetrabutylphosphonium bromide (manufactured by Hokko Chemical Industry Co., Ltd.) were added to 34.90 g of propylene glycol monomethyl ether in a reaction vessel and dissolved. The reaction vessel was purged with nitrogen, and the mixture was then reacted at 140°C for 24 hours to prepare a solution containing a polymer 7. As a result of GPC analysis, the polymer 7 obtained had a weight average molecular weight of 1030 in terms of standard polystyrene and a dispersity of 1.0. The structure present in the polymer 7 is represented by the following formula.

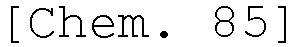

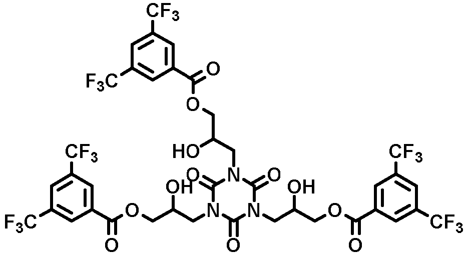

### <Synthesis Example 8>

First, 5.00 g of 1,3,5-tris (2,3-epoxypropyl)isocyanuric acid (trade name: TEPIC-SS, manufactured by Nissan Chemical Corporation), 13.80 g of 3,5-di-tert-butyl-4-hydroxybenzoic acid (manufactured by Tokyo Chemical Industry Co., Ltd.), and 0.64 g of tetrabutylphosphonium bromide (manufactured by Hokko Chemical Industry Co., Ltd.) were added to 19.43 g of propylene glycol monomethyl ether in a reaction vessel and dissolved. The reaction vessel was purged with nitrogen, and the mixture was then reacted at 140°C for 24 hours to prepare a solution containing a polymer 8. As a result of GPC analysis, the polymer 8 obtained had a weight average molecular weight of 1,060 in terms of standard polystyrene and a dispersity of 1.2. The structure present in the polymer 8 is represented by the following formula.

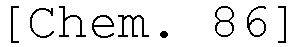

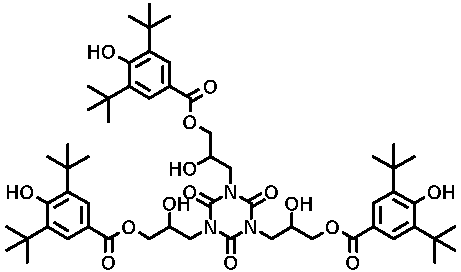

### <Synthesis Example 9>

First, 2.00 g of 1,3,5-tris (2,3-epoxypropyl)isocyanuric acid (trade name: TEPIC-SS, manufactured by Nissan Chemical Corporation), 9.39 g of tetrabromophthalic acid anhydride (manufactured by Midori Kagaku Co., Ltd.), and 0.26 g of tetrabutylphosphonium bromide (manufactured by Hokko Chemical Industry Co., Ltd.) were added to 27.16 g of propylene glycol monomethyl ether in a reaction vessel and dissolved. The reaction vessel was purged with nitrogen, and the mixture was then reacted at 140°C for 24 hours to prepare a solution containing a polymer 9. As a result of GPC analysis, the polymer 9 obtained had a weight average molecular weight of 910 in terms of standard polystyrene and a dispersity of 1.0. The structure present in the polymer 9 is represented by the following formula.

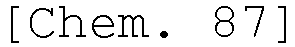

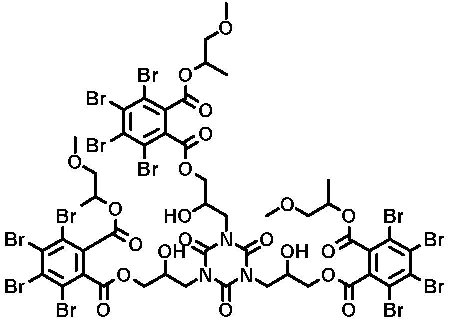

### <Synthesis Example 10>

First, 2.00 g of EPICLON HP-4700, trade name, (manufactured by DIC Corporation), 3.41 g of 3,5-di-tert-butyl-4-hydroxybenzoic acid (manufactured by Tokyo Chemical Industry Co., Ltd.), and 0.16 g of tetrabutylphosphonium bromide (manufactured by Hokko Chemical Industry Co., Ltd.) were added to 5.56 g of propylene glycol monomethyl ether in a reaction vessel and dissolved. The reaction vessel was purged with nitrogen, and the mixture was then reacted at 140°C for 24 hours to prepare a solution containing a polymer 10. As a result of GPC analysis, the polymer 10 obtained had a weight average molecular weight of 2,010 in terms of standard polystyrene and a dispersity of 1.6. The structure present in the polymer 10 is represented by the following formula.

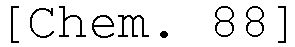

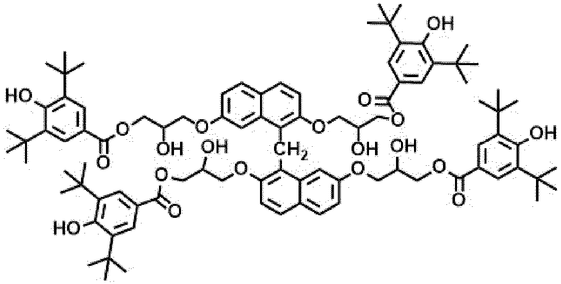

### <Comparative Synthesis Example 1>

First, 100.00 g of monoallyl diglycidyl isocyanuric acid (manufactured by Shikoku Chemicals Corporation), 66.4 g of 5,5-diethylbarbituric acid, and 4.1 g of benzyltriethylammonium chloride were added to 682.00 g of propylene glycol monomethyl ether in a reaction vessel and dissolved. The reaction vessel was purged with nitrogen, and the mixture was then reacted at 130°C for 24 hours to prepare a solution containing a comparative polymer 1. As a result of GPC analysis, the obtained comparative polymer 1 had a weight average molecular weight of 6,800 in terms of standard polystyrene, and a dispersity of 4.8. The structure present in the comparative polymer 1 is represented by the following formula.

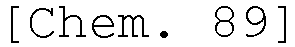

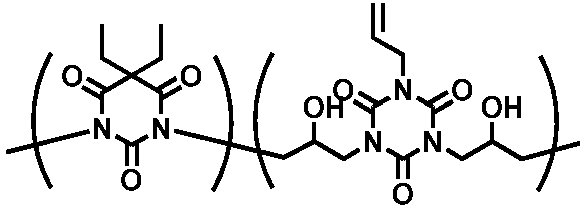

### (To prepare resist underlayer film-forming composition)

### (Examples and Comparative Examples)

Each polymer obtained in Synthesis Examples 1 to 10 or Comparative Synthesis Example 1, a crosslinking agent, a curing catalyst, and a solvent were mixed in the proportions shown in Tables 1-1 and 1-2 so that the solid content was about 0.19 mass%, and the mixture was filtered through a 0.1-µm fluororesin filter to prepare each composition for forming a resist underlayer film.

The meanings of the abbreviations in Tables 1-1 and 1-2 are shown below.
·PL-LI: Tetramethoxymethylglycoluril
·PGME-PL: Imidazo[4,5-d]imidazole-2,5(1H,3H)-dione, tetrahydro-1,3,4,6-tetrakis[(2-methoxy-1-methylethoxy)methyl] (the following structural formula) 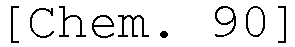 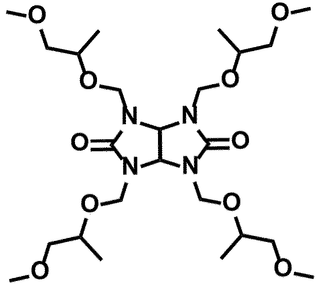
·PyPSA: Pyridinium p-hydroxybenzenesulfonate
·R-30N: Surfactant (manufactured by DIC Corporation)
·PGMEA: Propylene glycol monomethyl ether acetate
·PGME: Propylene glycol monomethyl ether

Each amount added was represented by parts by mass, and the solvent was indicated using a composition ratio.

**[Table 1-1]**

| | Polymer | Crosslinking agent | Curing catalyst | Additive | Solvent | |
|---|---|---|---|---|---|---|
| Example 1 | Synthesis Example 1 | PGME-PL | PyPSA | Synthesis Example 3 | PGME | PGMEA |
| (parts by mass) | 0.136 | 0.037 | 0.003 | 0.014 | 90 | 10 |
| Example 2 | Synthesis Example 1 | PGME-PL | PyPSA | Synthesis Example 4 | PGME | PGMEA |
| (parts by mass) | 0.136 | 0.037 | 0.003 | 0.014 | 90 | 10 |
| Example 3 | Synthesis Example 1 | PGME-PL | PyPSA | Synthesis Example 5 | PGME | PGMEA |
| (parts by mass) | 0.136 | 0.037 | 0.003 | 0.014 | 90 | 10 |
| Example 4 | Synthesis Example 1 | PGME-PL | PyPSA | Synthesis Example 6 | PGME | PGMEA |
| (parts by mass) | 0.136 | 0.037 | 0.003 | 0.014 | 90 | 10 |
| Example 5 | Synthesis Example 1 | PGME-PL | PyPSA | Synthesis Example 7 | PGME | PGMEA |
| (parts by mass) | 0.136 | 0.037 | 0.003 | 0.014 | 90 | 10 |
| Example 6 | Synthesis Example 1 | PGME-PL | PyPSA | Synthesis Example 8 | PGME | PGMEA |
| (parts by mass) | 0.141 | 0.039 | 0.004 | 0.007 | 90 | 10 |
| Example 7 | Synthesis Example 1 | PGME-PL | PyPSA | Synthesis Example 8 | PGME | PGMEA |
| (parts by mass) | 0.136 | 0.037 | 0.003 | 0.014 | 90 | 10 |
| Example 8 | Synthesis Example 1 | PGME-PL | PyPSA | Synthesis Example 9 | PGME | PGMEA |
| (parts by mass) | 0.136 | 0.037 | 0.003 | 0.014 | 90 | 10 |
| Example 9 | Synthesis Example 1 | PGME-PL | PyPSA | Synthesis Example 10 | PGME | PGMEA |
| (parts by mass) | 0.136 | 0.037 | 0.003 | 0.014 | 90 | 10 |
| Example 10 | Synthesis Example 2 | PGME-PL | PyPSA | Synthesis Example 8 | PGME | PGMEA |
| (parts by mass) | 0.136 | 0.037 | 0.003 | 0.014 | 90 | 10 |

**[Table 1-2]**

| | Polymer | Crosslinking agent | Curing catalyst | Surfactant | Solvent | |
|---|---|---|---|---|---|---|
| Comparative Example 1 | Comparative Synthesis Example 1 | PL-LI | PyPSA | R-30N | PGME | PGMEA |
| (parts by mass) | 0.149 | 0.037 | 0.003 | 0.001 | 70 | 30 |
| Comparative Example 2 | Synthesis Example 1 | PGME-PL | PyPSA | - | PGME | PGMEA |
| (parts by mass) | 0.149 | 0.037 | 0.003 | - | 90 | 10 |

### (Test of elution into photoresist solvent)

The resist underlayer film-forming compositions of Examples 1 to 10 or Comparative Examples 1 and 2 were each applied onto a silicon wafer by using a spinner. The silicon wafer was baked at 205°C for 60 seconds on a hot plate to obtain a film having a film thickness of 5 nm. These resist underlayer films were each immersed in a mixed solution of propylene glycol monomethyl ether/propylene glycol monomethyl ether acetate = 70/30 (mass ratio), which is a solvent used for the photoresist, and a case where the film thickness change was 5 Å or less was evaluated as "Good", and a case where the film thickness change was more than 5 Å was evaluated as "Poor", and the results are shown in Table 2.

**[Table 2]**

| | Elution test |
|---|---|
| Example 1 | Good |
| Example 2 | Good |
| Example 3 | Good |
| Example 4 | Good |
| Example 5 | Good |
| Example 6 | Good |
| Example 7 | Good |
| Example 8 | Good |
| Example 9 | Good |
| Example 10 | Good |
| Comparative Example 1 | Good |
| Comparative Example 2 | Good |

### (To measure water contact angle)

Whether or not the hydrophobicity of the surface of each resist underlayer film was increased by adding the hydrophobic additive was checked by measuring the water contact angle.

The resist underlayer film-forming compositions of Examples 1 to 10 or Comparative Example 2 were each applied onto a silicon wafer by using a spinner. The silicon wafer was baked at 205°C for 60 seconds on a hot plate to obtain a film having a film thickness of 5 nm. The water contact angle of each resist underlayer film was measured by a droplet method using a fully automatic contact angle meter DM-701 (manufactured by Kyowa Interface Science Co., Ltd.). The results are shown in Table 3.

**[Table 3]**

| | Contact angle (°) |
|---|---|
| Example 1 | 57 |
| Example 2 | 64 |
| Example 3 | 66 |
| Example 4 | 62 |
| Example 5 | 68 |
| Example 6 | 56 |
| Example 7 | 62 |
| Example 8 | 54 |
| Example 9 | 63 |
| Example 10 | 69 |
| Comparative Example 2 | 50 |

It was found that the contact angle was increased by the addition of the hydrophobic additive.

This has demonstrated that the hydrophobicity of the surface of the resist underlayer film is increased by the addition of the hydrophobic additive.

### (To evaluate resist patterning)

### [Test of resist pattern formation by using electron beam lithography system]

The resist underlayer film-forming compositions of Examples 1 to 10 or Comparative Examples 1 and 2 were each applied onto a silicon wafer by using a spinner. The silicon wafer was baked on a hot plate at 205°C for 60 seconds to obtain a resist underlayer film having a film thickness of 5 nm. A positive resist solution for EUV was spin-coated on the resist underlayer film, followed by heating to 105°C for 60 seconds to form an EUV resist film. The resist film was exposed under the predetermined conditions by using an electron beam lithography system (ELS-G130). After the exposure, the silicon wafer was baked (PEB) at 95°C for 60 seconds, cooled on a cooling plate to room temperature, and subjected to puddle developing for 30 seconds using a 2.38% aqueous tetramethylammonium hydroxide solution (trade name NMD-3 manufactured by Tokyo Ohka Kogyo Co., Ltd.) as a photoresist developer. A resist pattern having a line size of 18 nm to 32 nm was formed. A scanning electron microscope (CG4100 manufactured by Hitachi High-Technologies Corporation) was used to measure the length of the resist pattern.

With respect to the photoresist pattern thus obtained, a 28 nm line-and-space (L/S) was formed. In all the cases of Examples 1 to 10, 28 nm L/S pattern formation was observed. In addition, while the amount of electric charge when a 28 nm line/56 nm pitch (line-and-space (L/S= 1/1)) was formed is defined as the optimum irradiation energy, the irradiation energy (µC/cm²) at that time, the minimum critical dimension (CD) size at which no collapse is observed in the shot of the resist pattern, and the line width roughness (LWR) are shown in Table 4. In Examples 1 to 10, it was found that the optimum irradiation energy was lower than that of Comparative Example 2, and in Examples 1 to 10, it was found that the minimum CD size was improved and the LWR was decreased as compared with Comparative Example 1.

**[Table 4]**

| | Irradiation energy (uC/cm²) | Minimum CD size (nm) | LWR (nm) |
|---|---|---|---|
| Example 1 | 475 | 19.9 | 3.17 |
| Example 2 | 476 | 19.8 | 3.17 |
| Example 3 | 479 | 20.0 | 3.16 |
| Example 4 | 475 | 19.6 | 3.03 |
| Example 5 | 469 | 19.1 | 3.03 |
| Example 6 | 476 | 19.2 | 3.00 |
| Example 7 | 483 | < 19.9 | 3.02 |
| Example 8 | 432 | 21.1 | 3.16 |
| Example 9 | 439 | 21.1 | 3.20 |
| Example 10 | 475 | 20.2 | 3.19 |
| Comparative Example 1 | 477 | 21.7 | 3.23 |
| Comparative Example 2 | 495 | < 20.0 | 2.99 |

## Claims

1. A resist underlayer film-forming composition comprising a polymer (A), a hydrophobic substituent-containing compound (B), and a solvent (C).

2. The resist underlayer film-forming composition according to claim 1, wherein the polymer (A) is at least one of an isocyanuric acid-based polymer, a polyester-based polymer, an acrylic polymer, or a polyether.

3. The resist underlayer film-forming composition according to claim 1, wherein the polymer (A) is a polymer having a hydroxy group in a unit structure.

4. The resist underlayer film-forming composition according to claim 1, wherein the hydrophobic substituent of the compound (B) is an optionally substituted aryl group or an optionally substituted C₁₋₁₀ alkyl group.

5. The resist underlayer film-forming composition according to claim 1, wherein the solvent (C) contains at least one selected from the group consisting of alkylene glycol monoalkyl ether and monocarboxylic acid esters of alkylene glycol monoalkyl ether.

6. The resist underlayer film-forming composition according to claim 1, further comprising a crosslinking agent (D).

7. The resist underlayer film-forming composition according to claim 6, wherein the crosslinking agent (D) is at least one selected from the group consisting of aminoplast crosslinking agent and phenoplast crosslinking agent.

8. The resist underlayer film-forming composition according to claim 1, further comprising a curing catalyst (E).

9. A resist underlayer film that is a cured product of the resist underlayer film-forming composition according to any one of claims 1 to 8.

10. A laminate comprising:
a semiconductor substrate; and
the resist underlayer film according to claim 9.

11. A method for producing a semiconductor element, the method comprising the steps of:
forming a resist underlayer film on a semiconductor substrate by using the resist underlayer film-forming composition according to any one of claims 1 to 8; and
forming a resist film on the resist underlayer film.

12. A method of forming a pattern, the method comprising the steps of:
forming a resist underlayer film on a semiconductor substrate by using the resist underlayer film-forming composition according to any one of claims 1 to 8;
forming a resist film on the resist underlayer film;
irradiating the resist film with light or an electron beam and then developing the resist film to obtain a resist pattern; and
etching the resist underlayer film by using the resist pattern as a mask.
